(19) **Europäisches Patentamt**
**European Patent Office**
**Office européen des brevets**

(11) **EP 2 802 079 B1**

(12) **EUROPEAN PATENT SPECIFICATION**

(45) Date of publication and mention
of the grant of the patent:
**19.04.2017 Bulletin 2017/16**

(51) Int Cl.:
*H03M 13/03* *(2006.01)*    *H03M 13/11* *(2006.01)*
*H03M 13/25* *(2006.01)*    *H03M 13/27* *(2006.01)*
*H03M 13/29* *(2006.01)*    *H03M 13/15* *(2006.01)*

(21) Application number: **14167686.6**

(22) Date of filing: **09.05.2014**

(54) **Apparatus and method for improved modulation and coding schemes for broadband satellite communications systems**

Vorrichtung und Verfahren zur verbesserten Modulation und Codierung für breitbandige Satellitenkommunikationssysteme

Appareil et procédé de schémas de modulation et de codage améliorés pour systèmes de communications par satellite à large bande

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.05.2013 US 201313890643**

(43) Date of publication of application:
**12.11.2014 Bulletin 2014/46**

(73) Proprietor: **Hughes Network Systems, LLC
Germantown, MD 20876 (US)**

(72) Inventors:
• **Eroz, Mustafa
Germantown, MD Maryland 20874 (US)**
• **Lee, Lin-Nan
Potomac, MD Maryland 20854 (US)**

(74) Representative: **Körfer, Thomas
Mitscherlich PartmbB
Patent- und Rechtsanwälte
Sonnenstrasse 33
80331 München (DE)**

(56) References cited:

• **"Digital Video Broadcasting (DVB);Second generation framing structure, channel coding and modulation systems for Broadcasting,Interactive Services, News Gathering and other broadband satellite applications (DVB-S2)", ETSI EN 302 307 V1.2.1, SOPHIA ANTIPOLIS CEDEX - FRANCE , vol. 302 307, no. V1.2.1 1 August 2009 (2009-08-01), pages 22-28,37, XP002678089, Retrieved from the Internet: URL:http://www.etsi.org/deliver/etsi_en/30 2300_302399/302307/01.02.01_60/ en_302307v010201p.pdf [retrieved on 2012-06-19]**
• **DVB ORGANIZATION: "CfT_Hughes_r1.pdf", DVB, DIGITAL VIDEO BROADCASTING, C/O EBU - 17A ANCIENNE ROUTE - CH-1218 GRAND SACONNEX, GENEVA - SWITZERLAND, 13 February 2013 (2013-02-13), XP017840327,**
• **DVB ORGANIZATION: "Short_Modcod_Presentation_for_Sx.pptx", DVB, DIGITAL VIDEO BROADCASTING, C/O EBU - 17A ANCIENNE ROUTE - CH-1218 GRAND SACONNEX, GENEVA - SWITZERLAND, 21 May 2013 (2013-05-21), XP017841234,**
• **DVB ORGANIZATION: "Sx_new_modcods.docx", DVB, DIGITAL VIDEO BROADCASTING, C/O EBU - 17A ANCIENNE ROUTE - CH-1218 GRAND SACONNEX, GENEVA - SWITZERLAND, 4 July 2013 (2013-07-04), XP017841240,**

- **DVB ORGANIZATION: "tm4878.Sx_new_modcods[1].pdf", DVB, DIGITAL VIDEO BROADCASTING, C/O EBU - 17A ANCIENNE ROUTE - CH-1218 GRAND SACONNEX, GENEVA - SWITZERLAND, 3 June 2013 (2013-06-03), XP017840644,**

**Description**

BACKGROUND

Over recent decades, developments in data communications technologies have continued to provide enhanced multimedia services (e.g., voice, data, video, etc.) to end-users. Such communications technologies encompass various delivery platforms, including terrestrial wire-line, fiber and wireless communications and networking technologies, and satellite communications and networking technologies. Further, in recent years, the proliferation of mobile communications has spurred an exponential growth in the provision of such enhanced multimedia services over mobile communications networks (both terrestrial and satellite based). As part of the continued evolution of such communications platforms and supporting technologies, the Digital Video Broadcasting (DVB) organization was formed (as an industry-led, global consortium of broadcasters, manufacturers, network operators, software developers, regulatory bodies and others) to advance the design of open interoperable standards for the global delivery of digital media and broadcast services.

As part of the standardization process for digital media and broadcast services, the DVB organization managed the adoption and publication of the DVB-S2 standard via recognized standards setting organizations (e.g., ETSI and TIA). DVB-S2 is a digital satellite transmission system standard covering framing structure, channel coding and modulation systems, designed for broadcast services (for standard and high definition television), interactive services (e.g., Internet access for consumer applications), and other broadband satellite applications. DVB-S2 represents a flexible standard, covering a variety of data and multimedia services delivered over satellite communications systems. The DVB-S2 standard covers various technological features, such as a flexible input stream adapter (suitable for operation with single and multiple input streams of various formats), a robust forward error correction coding (FEC) system based on low-density parity check (LDPC) codes concatenated with Bose Chaudhuri Hocquenghem (BCH) codes, a wide range of code rates (from 1/4 up to 9/10), four signal constellations (ranging in spectrum efficiency from 2 bit/s/Hz to 5 bit/s/Hz), and adaptive coding and modulation (ACM) functionality (optimizing channel coding and modulation on a frame-by-frame basis).

Since its inception, the DVB-S2 standard has been adopted globally as a predominant standard for broadcast, interactive and other broadband applications and services over satellite communications networks. Currently, there are applications and services for terminals, particularly in the field of mobile communications, that require operation at lower signal-to-noise ratios ($E_s/N_0$), down to approximately -9 dB to -10 dB. The current modulation and coding schemes (e.g., the modulation and coding schemes of the DVB-S2 standard), however, support operation down to $E_s/N_0$ ratios of only about -3 dB, and thus are unable to support the operational requirements for such current mobile and other low signal-to-noise ratio (SNR) terminals (e.g., below -3 dB). Further, the modulation and coding schemes of the current DVB-S2 standard ($E_s/N_0$ ratios within the range of approximately -3 dB to 15.5 dB) lack sufficient granularity to meet the requirements of terminals in the growing field of broadcast, interactive and other broadband applications and services over satellite communications networks.

What is needed, therefore, are systems and methods for providing modulation and coding schemes that support current and future communications services and applications for terminals with operational requirements at relatively low SNR and terminals, and to provide modulation and coding schemes that offer finer granularity (among existing modulation and coding schemes) within an intermediate operational range.

The invention is defined by the independent claims 1 and 9. The dependent claims comprise further developments of the invention.

SOME EXEMPLARY EMBODIMENTS

The present invention advantageously addresses the foregoing requirements and needs, as well as others, by providing a system and methods for providing modulation and coding schemes that support current and future communications services and applications for terminals with operational requirements at relatively low $E_s/N_0$ ratios (e.g., within the operational range of approximately -3 dB to -10 dB), and to provide modulation and coding schemes that offer finer granularity within an intermediate operational range of $E_s/N_0$ ratios (e.g., approximately -3 dB to 15.5 dB).

According to an exemplary embodiment, a method comprises encoding, by a processor of a device, a source data sequence of information bits based on a predetermined structured parity check matrix of a Low Density Parity Check (LDPC) code, wherein the encoding is performed based on frames of the source data sequence, each frame being of a length of $k_{ldpc}$ information bits ($i_0, i_1, ...,i_{k_{ldpc}-1}$), and the output of the encoding comprises coded LDPC frames each being $n_{ldpc}$ coded bits in length. The structured parity check matrix is represented by tabular information (a code table) of a format wherein each row represents occurrences of one values within a respective column of the parity check matrix, and the columns of the parity check matrix are derived according to a predetermined operation based on the respective rows of the tabular information, and wherein the code table comprises one of a selection of new LDPC code designs (each represented by a respective code table). According to the method, the encoding wherein the encoding comprises generating $n_{ldpc} - k_{ldpc}$ parity bits ($p_0, p_1, ..., p_{n_{ldpc}-k_{ldpc}-1}$) for each frame of the source data sequence, wherein the generation of the parity bits comprises: initializing parity bit accumulators for $p_0, p_1,..., p_{n_{ldpc}-k_{ldpc}-1}$ to zero; accumulating information bit $i_0$ at parity bit accumulator addresses specified in the first row of the table; for the next group of $m$ - 1 information bits, $iy$ ($y = 1, 2, ..., m$ - 1), accumulating each information bit at parity bit accumulator addresses $\{x + (y \bmod m) * q\} \bmod (n_{ldpc} - k_{ldpc})$, wherein $x$ denotes an address of a parity bit accumulator corresponding to the information bit $i_0$, and $q$ is a code-rate dependent constant ($q = (n_{ldpc} - k_{ldpc})/m$), and wherein $m$ is a code-dependent constant and $k_{ldpc} = R * n_{ldpc}$ (where $R$ is the code rate); accumulating $i_m$ at parity bit accumulator addresses specified in the second row of the table, and, in a similar manner as for the group of $m$ - 1 information bits (above), accumulating each information bit of the next group of $m$ - 1 information bits $i_z$, $z = (m + 1, m + 2, ... , 2m)$ at $\{x + (z \bmod m) * q\} \bmod (n_{ldpc} - k_{ldpc})$, wherein $x$ denotes the address of the parity bit accumulator corresponding to the information bit $i_m$ (the entries of the second row of the table); in a similar manner, for each subsequent group of $m$ information bits, accumulating the information bits at parity bit addresses based on a next row of the table; and after all of the information bits of the frame are accumulated, performing operations according to $p_i = p_i \oplus p_{i-1}$, wherein for $i = 1, 2, ..., (n_{ldpc} - k_{ldpc} - 1)$, each $p_i$ resulting from the operation for a given $i$ is equal to the parity bit $p_i$.

According to a further exemplary embodiment, the method further comprises interleaving each coded LDPC frame using a block interleaver, wherein the coded bits are written into an interleaver array on a column-by-column basis and read out on a row-by-row basis, and the output of the interleaving comprises coded FEC frames. The interleaver array comprises a number of rows and a number of columns, and the coded bits are read out of each row in a predetermined order, wherein the number of columns in the interleaver array is based on a selected modulation scheme, and the coded bits are read out of each row of the interleaver array in a predetermined order based on the selected modulation scheme and a selected code rate.

According to yet a further exemplary embodiment, the method further comprises modulating the coded FEC frames according to a selected modulation scheme, wherein the selected modulation scheme comprises one of the following modulation types: π/2 BPSK (Binary Phase Shift Keying), QPSK (Quadrature Phase Shift Keying), 8-PSK (Phase Shift Keying), 16-APSK (Amplitude Phase Shift Keying), and 32-APSK, wherein, in the case of π/2 BPSK or QPSK, the coded FEC frames are not interleaved.

Still other aspects, features, and advantages of the present invention are readily apparent from the following detailed description, simply by illustrating a number of particular embodiments and implementations, including the best mode contemplated for carrying out the present invention. The present invention is also capable of other and different embodiments, and its several details can be modified in various obvious respects. Accordingly, the drawing and description are to be regarded as illustrative in nature, and not as restrictive.

BRIEF DESCRIPTION OF THE DRAWINGS

The present invention is illustrated by way of example, and not by way of limitation, in the figures of the accompanying drawings and in which like reference numerals refer to similar elements and in which:

**FIG. 1A** illustrates a communications system capable of employing modulation and coding protocols, in accordance with exemplary embodiments of the present invention;

**FIG. 1B** illustrates a satellite communications system capable of employing modulation and coding protocols, in accordance with exemplary embodiments of the present invention;

**FIG. 2A** illustrates a block diagram of an exemplary transmitter configured to operate in the systems of **FIGs. 1A and 1B,** in accordance with exemplary embodiments of the present invention;

**FIG. 2B** illustrates a block diagram of an exemplary receiver configured to operate in the systems of **FIGs. 1A and 1B,** in accordance with exemplary embodiments of the present invention;

**FIG. 3A** illustrates the bit interleaving scheme for the 8PSK modulation formats (for all rates except rate 3/5) of the DVB-S2 standard for the normal FEC Frame length;

**FIG. 3B** illustrates the bit interleaving scheme for the 8PSK modulation formats (for rate 3/5 only) of the DVB-S2 standard for the normal FEC Frame length;

**FIG. 4** illustrates a prior art 32APSK (4+12+16) signal constellation;

**FIG. 5** illustrates simulated performance curves for the provided modulation and coding schemes over an AWGN channel, in accordance with exemplary embodiments of the present invention;

**FIG. 6** illustrates a flow chart of an exemplary process for encoding and modulating a source data sequence of information bits, in accordance with exemplary embodiments of the present invention;

**FIG. 7** illustrates a flow chart of an exemplary process for demodulating and decoding a received data signal transmission to replicate a source data sequence of information bits that was encoded and modulated, in accordance with exemplary embodiments of the present invention;

**FIG. 8** illustrates a block diagram of a chip set that can be utilized in implementing communications system protocols, according to exemplary embodiments of the present invention.

DETAILED DESCRIPTION

A system and methods for communications system protocols to support communications services and applications over relatively low signal-to-noise ratio ($E_s/N_0$) links, is described. In the following description, for the purposes of explanation, numerous specific details are set forth in order to provide a thorough understanding of the invention. It is apparent, however, that the invention may be practiced without these specific details or with an equivalent arrangement. In other instances, well known structures and devices are shown in block diagram form in order to avoid unnecessarily obscuring the invention.

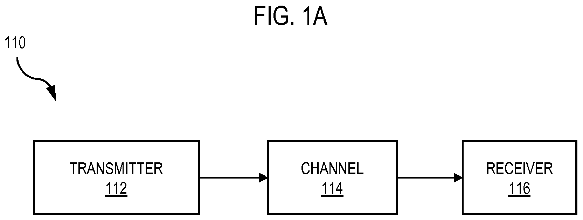

**FIG. 1A** illustrates a communications system capable of employing modulation and coding protocols, in accordance with exemplary embodiments of the present invention. With reference to **FIG. 1A**, a broadband communications system 110 includes one or more transmitters 112 (of which one is shown) that generate signal waveforms for transmission to one or more receivers 116 (of which one is shown). The signal waveforms are transmitted across a communications channel 114, which (for example) may comprise a channel of a terrestrial, wireless terrestrial or satellite communications system. In this discrete communications system 110, the transmitter 112 has a signal source that produces a discrete set of data signals, where each of the data signals is transmitted over a corresponding signal waveform. The discrete set of data signals may first be encoded (e.g., via a forward error correction (FEC) code) to combat noise and other issues associated with the channel 114. Once encoded, the encoded signals may then be modulated onto a carrier for transmission over the channel 114. The signal waveforms are attenuated, or otherwise altered, by communications channel 114.

FEC is required in terrestrial and satellite systems to provide high quality communication over a radio frequency (RF) propagation channel, which induces signal waveform and spectrum distortions, including signal attenuation (freespace propagation loss), multi-path induced fading and adjacent channel interference. These impairments drive the design of the radio transmission and receiver equipment; exemplary design objectives include selecting modulation formats, error control schemes, demodulation and decoding techniques and hardware components that together provide an efficient balance between system performance and implementation complexity. Differences in propagation channel characteristics, such as between terrestrial and satellite communication channels, naturally result in significantly different system designs. Likewise, existing communications systems continue to evolve in order to satisfy increased system requirements for new higher rate or higher fidelity communication services.

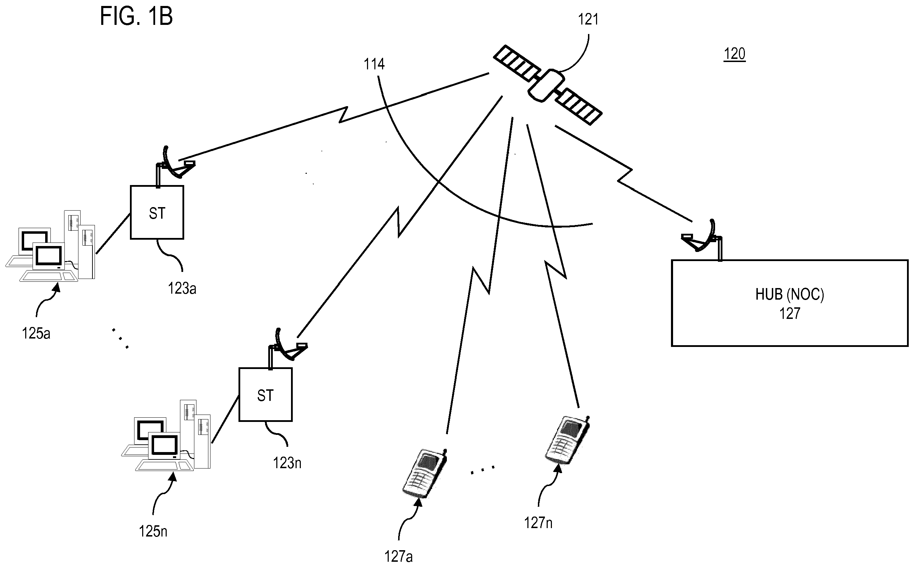

**FIG. 1B** illustrates a satellite communications system capable of employing modulation and coding protocols, in accordance with exemplary embodiments of the present invention. With reference to **FIG. 1B**, satellite communications system 120 includes a satellite 121 that supports communication among multiple satellite terminals (STs) 123a-123n, user terminals (UTs) 127a-127n, and a hub 127. The HUB 127 may assume the role of a Network Operations Center (NOC), which controls the access of the STs 123a-123n and UTs 127a-127n to the system 120, and also provides element management functions and control of the address resolution and resource management functionality. The Satellite communications system 120 may operate as a traditional bent-pipe system, where the satellite essentially operates as a repeater. Alternatively, the system 120 may employ a switching or processing satellite supporting mesh communications (point-to-point communications directly between a pair of the STs 123a-123n and UTs 127a-127n).

In a traditional bent-pipe system of an exemplary embodiment, for example, the satellite operates as a repeater or bent pipe, and communications between the STs 123a-123n and UTs 127a-127n are transmitted over a double-hop path. For example, in a communication from ST 123a to ST 123n, over the first hop, the communication is transmitted, via the satellite, from the ST 123a to the HUB 127. The HUB 127 decodes the communication and determines the destination as ST 123n. The HUB 127 then appropriately addresses and repackages the communication, encodes and modulates it, and transmits the communication over the second hop, via the satellite, to the destination ST 123n. Accordingly, the satellite of such a system acts as a bent pipe or repeater, transmitting communications between the HUB 127 and the STs/UTs.

In an alternate embodiment, with a communications system 120 that employs a processing satellite (e.g., including a packet switch operating, for example, at a data link layer), the system may support direct unicast (point-to-point) communications and multicast communications among the STs 123a-123n and UTs 127a-127n. In the case of a processing satellite, the satellite 121 decodes the received signal and determines the destination ST(s)/UT(s) (as the hub 127 would in a bent-pipe system). The satellite 121 then addresses the data accordingly, encodes and modulates it, and transmits the modulated signal, over the channel 114, to the destination ST(s)/UT(s). Further, the STs 123a-123n may each provide connectivity to one or more respective hosts (e.g., hosts 125a-125n, respectively).

Further, based on recent trends in the advancement of current applications and services and in the development of new applications and services, it is envisioned that systems employing a multiplexing of data signals on the same channel 114 (e.g., time multiplexed), where (on a frame-by-frame basis) such data signals may be destined for different receive terminals of different capabilities (e.g., any combination of STs 125a-125n and UTs 127a-127n. For example, data signals destined for high S/N terminals (e.g., any of the STs 125a-125n) may be multiplexed with data signals destined for lower S/N terminals (e.g., any of the UTs 127a-127n), on the same channel 114 (on a frame-by-frame basis).

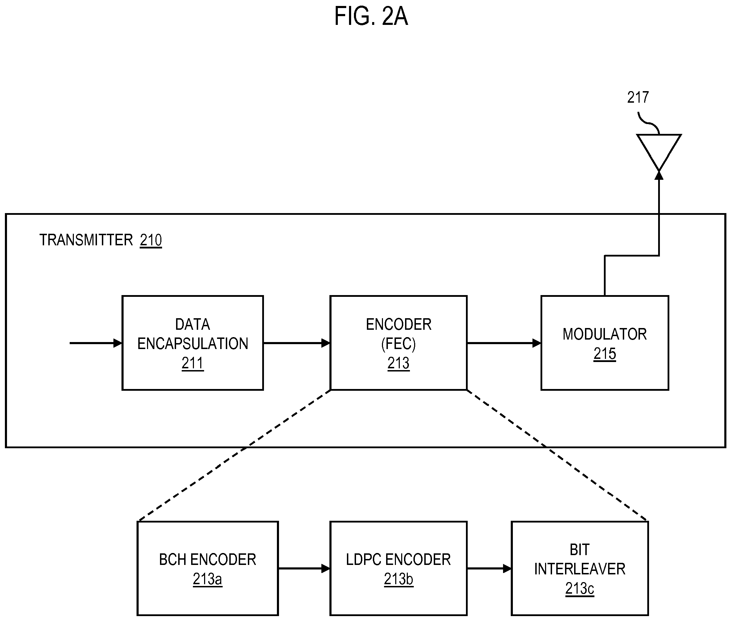

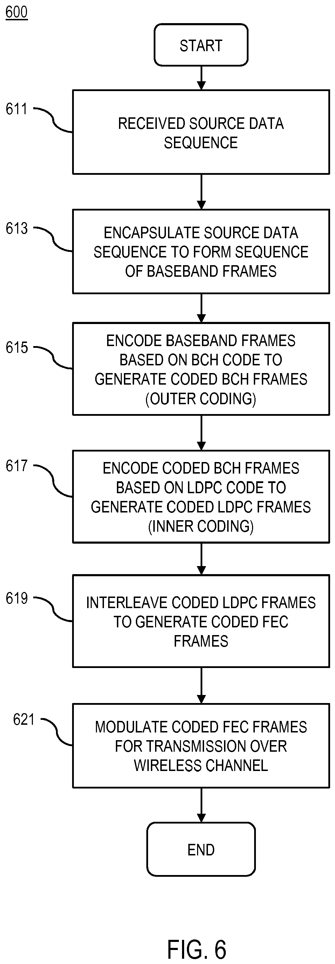

**FIG. 2A** illustrates a block diagram of an exemplary transmitter configured to operate in the systems of **FIGs. 1A and 1B**, in accordance with exemplary embodiments of the present invention. With reference to **FIG. 2A**, the transmitter 210 is equipped with a data encapsulation module 211 that accepts the original application layer source data and performs the upper layer encapsulation to from the baseband frames. The encoder (e.g., an FEC encoder) 213 receives the baseband frames from the data encapsulation module 211, and outputs a coded stream of higher redundancy suitable for error correction processing at the receiver (shown in FIG. 6). The encoded signal is fed to the modulator 215, which maps the encoded messages to signal waveforms, based in part on modulation signal constellations. For example, the data encapsulation module 211 performs the upper layer encapsulation to generate the baseband frames based on the source data bits, and then the encoder 213 and modulator 215 collectively perform the modulation and coding of the baseband frames and the generation of the physical layer frames, in accordance with the exemplary embodiments of the present invention. The physical layer frames are then transmitted (as signal waveforms), via the transmit antenna 217, over the communication channel 114 to the satellite 121.

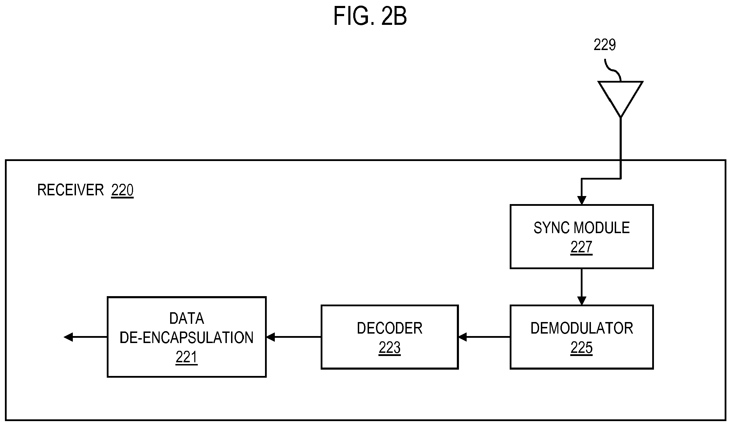

**FIG. 2B** illustrates a block diagram of an exemplary receiver configured to operate in the systems of **FIGs. 1A and 1B**, in accordance with exemplary embodiments of the present invention. With reference to **FIG. 2B**, the receiver 220 comprises receive antenna 229, sync module 227 demodulator 225, decoder 223 and de-encapsulation module 221. The receive antenna 229 receives the signal waveform transmitted over the channel 114 from the satellite 121. The sync module 227 detects the unique word, performs synchronization and determines the modcod and other PLS signaling of the PL Header. The demodulator 225 demodulates the received signal waveforms, based in part on the signal constellation employed for the modulation, to obtain the encoded signals. The decoder 223 then decodes the demodulated bit sequence to generate the encapsulated message data, and the de-encapsulation module 221 de-encapsulates the message data to regenerate the original source data.

As mentioned above, as one exemplary embodiment for broadcast and broadband communications services over satellite networks, the DVB-S2 standard has been adopted globally as a predominant standard for broadcast, interactive and other broadband services and applications. The framing structure, channel coding and modulation systems of the DVB-S2 standard are described in the European Telecommunications Standards Institute (ETSI) publication, ETSI EN 302 307 V1.3.1. DVB-S2 represents a flexible standard, covering a variety of data and multimedia services delivered over satellite communications systems. Generic Stream Encapsulation (GSE) protocols may be employed to provide a data link layer protocol that facilitates the transmission of user or application data from packet oriented protocols (e.g., Internet protocol or IP) on top of a unidirectional physical layer protocol (e.g., DVB-S2). According to the GSE protocol, application data in the form of packet data units (PDUs) are first encapsulated within the baseband frames of the communications network (e.g., DVB-S2 baseband packets in a satellite communications system).

The DVB-S2 standard, for example, was designed to facilitate robust synchronization and signaling at the physical layer, and synchronization and detection of the modulation and coding parameters by a receiver before demodulation and FEC decoding. At the physical layer, baseband frames are encoded to form an output stream of FEC Frames. For example, the baseband frames are encoded by the FEC encoder 213, which comprises a t-error BCH outer coding via the BCH encoder 213a, an LDPC inner coding via the LDPC encoder 213b, and bit interleaving via the bit interleaver 213c. The interleaver 213c reorders the encoded sequence of symbols or bits from the LDPC encoder 213b in a predetermined manner. More specifically, the FEC coding subsystem of DVB-S2 comprises a BCH outer coding, LDPC inner coding and bit interleaving. The input to the FEC subsystem consists of a data stream of baseband frames, where each baseband frame of $K_{bch}$ bits is processed by the coding system to produce an FEC Frame of $n_{ldpc}$ bits, where $n_{ldpc}$ = 64,800 for a normal FEC Frame and $n_{ldpc}$ = 16,200 for a short FEC Frame.

Physical Layer framing is then performed, by slicing the XFEC Frames into a number of fixed length slots (of length M = 90 symbols each), to generate the physical layer frames, as specified in Section 5.5 of the above-referenced DVB-S2 publication, ETSI EN 302 307.

For the outer BCH coding, the BCH coding parameters are specified in the following tables:

Table 1a: Coding Parameters (normal FEC Frame - LDPC Coded Block $n_{ldpc}$ = 64800)

| LDPC Code Rate | BCH Uncoded Block $K_{bch}$ | BCH Coded Block $N_{bch}$ LDPC Uncoded Block $k_{ldpc}$ | BCH t-Error Correction (bits) |
|---|---|---|---|
| 1/4 | 16008 | 16200 | 12 |
| 1/3 | 21408 | 21600 | 12 |
| 2/5 | 25728 | 25920 | 12 |
| 1/2 | 32208 | 32400 | 12 |
| 3/5 | 36688 | 38880 | 12 |
| 2/3 | 43040 | 43200 | 10 |
| 3/4 | 48408 | 48600 | 12 |
| 4/5 | 51648 | 51840 | 12 |
| 5/6 | 53840 | 54000 | 10 |
| 8/9 | 57472 | 57600 | 8 |
| 9/10 | 58192 | 58320 | 8 |

Table 1b: Coding Parameters (short FEC Frame - LDPC Coded Block $n_{ldpc}$ = 16200)

| LDPC Code Rate | BCH Uncoded Block $K_{bch}$ | BCH Coded Block $N_{bch}$ LDPC Uncoded Block $k_{ldpc}$ | BCH t-Error Correction (bits) | Effective LDPC Rate ($k_{ldpc}$/16200) |
|---|---|---|---|---|
| 1/4 | 3072 | 3240 | 12 | 1/5 |
| 1/3 | 5232 | 5400 | 12 | 1/3 |
| 2/5 | 6312 | 6480 | 12 | 2/5 |
| 1/2 | 7032 | 7200 | 12 | 4/9 |
| 3/5 | 9552 | 9720 | 12 | 3/5 |
| 2/3 | 10632 | 10800 | 12 | 2/3 |
| 3/4 | 11712 | 11880 | 12 | 11/15 |
| 4/5 | 12432 | 12600 | 12 | 7/9 |
| 5/6 | 13152 | 13320 | 12 | 37/45 |
| 8/9 | 14232 | 14400 | 12 | 8/9 |
| 9/10 | N/A | N/A | N/A | N/A |

The generator polynomial of the BCH encoder is obtained by multiplying the first t polynomials specified in the following tables:

Table 2a: BCH Polynomials (normal FEC Frame - LDPC Coded Block $n_{ldpc}$ = 64800)

| $g_1(x)$ | $1+x^2+x^3+x^5+x^{16}$ |
|---|---|
| $g_2(x)$ | $1+x+x^4+x^5+x^6+x^8+x^{16}$ |
| $g_3(x)$ | $1+x^2+x^3+x^4+x^5+x^7+x^8+x^9+x^{10}+x^{11}+x^{16}$ |
| $g_4(x)$ | $1+x^2+x^4+x^6+x^9+x^{11}+x^{12}+x^{14}+x^{16}$ |
| $g_5(x)$ | $1+x+x^2+x^3+x^5+x^8+x^9+x^{10}+x^{11}+x^{12}+x^{16}$ |
| $g_6(x)$ | $1+x^2+x^4+x^5+x^7+x^8+x^9+x^{10}+x^{12}+x^{13}+x^{14}+x^{15}+x^{16}$ |

(continued)

| | |
|---|---|
| $g_7(x)$ | $1+x^2+x^5+x^6+x^8+x^9+x^{10}+x^{11}+x^{13}+x^{15}+x^{16}$ |
| $g_8(x)$ | $1+x+x^2+x^5+x^6+x^8+x^9+x^{12}+x^{13}+x^{14}+x^{16}$ |
| $g_9(x)$ | $1+x^5+x^7+x^9+x^{10}+x^{11}+x^{16}$ |
| $g_{10}(x)$ | $1+x+x^2+x^5+x^7+x^8+x^{10}+x^{12}+x^{13}+x^{14}+x^{16}$ |
| $g_{11}(x)$ | $1+x^2+x^3+x^5+x^9+x^{11}+x^{12}+x^{13}+x^{16}$ |
| $g_{12}(x)$ | $1+x+x^5+x^6+x^7+x^9+x^{11}+x^{12}+x^{16}$ |

Table 2b: BCH Polynomials (short FEC Frame - LDPC Coded Block $n_{ldpc}$ = 16200)

| | |
|---|---|
| $g_1(x)$ | $1+x+x^3+x^5+x^{14}$ |
| $g_2(x)$ | $1+x^6+x^8+x^{11}+x^{14}$ |
| $g_3(x)$ | $1+x+x^2+x^6+x^9+x^{10}+x^{14}$ |
| $g_4(x)$ | $1+x^4+x^7+x^8+x^{10}+x^{12}+x^{14}$ |
| $g_5(x)$ | $1+x^2+x^4+x^6+x^8+x^9+x^{11}+x^{13}+x^{14}$ |
| $g_6(x)$ | $1+x^3+x^7+x^8+x^9+x^{13}+x^{14}$ |
| $g_7(x)$ | $1+x^2+x^5+x^6+x^7+x^{10}+x^{11}x^{13}+x^{14}$ |
| $g_8(x)$ | $1+x^5+x^8+x^9+x^{10}+x^{11}+x^{14}$ |
| $g_9(x)$ | $1+x+x^2+x^3+x^9+x^{10}+x^{14}$ |
| $g_{10}(x)$ | $1+x^3+x^6+x^9+x^{11}+x^{12}+x^{14}$ |
| $g_{11}(x)$ | $1+x^4+x^{11}+x^{12}+x^{14}$ |
| $g_{12}(x)$ | $1+x+x^2+x^3+x^5+x^6+x^7+x^8+x^{10}+x^{13}+x^{14}$ |

The BCH encoding of information bits $m = (m_{k_{bch}-1}, m_{k_{bch}-2},..., m_1, m_0)$ onto a codeword $c = (m_{k_{bch}-1}, m_{k_{bch}-2},... m_1, m_0, d_{n_{bch}-k_{bch}-1}, d_{n_{bch}-k_{bch}-2},... d_1, d_0)$ is achieved as follows: (1) multiply the message polynomial $m(x) = (m_{k_{bch}-1}x^{k_{bch}-1} + m_{kbch-2}x^{k_{bch}-2} + ... + m_1x + m_0)$ by $x^{n_{bch}-k_{bch}}$; (2) divide $x^{n_{bch}-k_{bch}}m(x)$ by the generator polynomial $g(x)$, where $d(x) = (d_{n_{bch}-k_{bch}-1}x^{n_{bch}-k_{bch}-1} + \cdots + d_1x + d_0)$ is the remainder; and (3) set the codeword polynomial $c(x) = x^{n_{bch}-k_{bch}}m + d(x)$.

Next, for the LDPC inner coding, the LDPC encoder systematically encodes an information block of size $k_{ldpc}$, $i = (0, i_0, i_1, ... , i_{k_{ldpc}-1})$ onto a codeword of size $n_{ldpc}$, $c = (i_0, i_1, ... i_{k_{ldpc}-1}, p_0, p_1, ..., p_{n_{ldpc}-k_{ldpc}-1})$. The transmission of the codeword starts in the given order from $i_0$ and ends with $p_{n_{ldpc}-k_{ldpc}-1}$. The LDPC code parameters ($k_{ldpc}$, $n_{ldpc}$) are specified in the above tables 1a and 1b. For backwards compatible modes, the output of the inner code is processed according to Annex F of the above-referenced DVB-S2 publication, ETSI EN 302 307.

The task of the LDPC encoder is to determine $n_{ldpc} - k_{ldpc}$ parity bits ($p_0, p_1, ... p_{n_{ldpc}-k_{ldpc}-1}$) for every block of $k_{ldpc}$ information bits ($i_0, i_1, ..., i_{k_{ldpc}-1}$). The procedure is as follows: (1) initialize $p_0 = p_1 = \cdots = p_{n_{ldpc}-k_{ldpc}-1} = 0$; (2) for the first information bit $i_0$, accumulate $i_0$ at the parity bit addresses specified in the first row of the table for the respective code rate and FEC Frame size - The tables are specified in Annexes B and C of the above-referenced DVB-S2 publication, ETSI EN 302 307. For example, for the rate 2/3 code for $n_{ldpc}$ = 64800 (Table B.6 of Annex B), where all additions are in GF(2):

$$p_0 = p_0 \oplus i_0 \qquad\qquad p_{2767} = p_{2767} \oplus i_0$$

$$p_{10491} = p_{10491} \oplus i_0 \qquad\qquad p_{240} = p_{240} \oplus i_0$$

$$p_{16043} = p_{16043} \oplus i_0 \qquad\qquad p_{18673} = p_{18673} \oplus i_0$$

$$p_{506} = p_{506} \oplus i_0 \qquad\qquad p_{9279} = p_{9279} \oplus i_0$$

$$p_{12826} = p_{12826} \oplus i_0 \qquad\qquad p_{10579} = p_{10579} \oplus i_0$$

$$p_{8065} = p_{8065} \oplus i_0 \qquad\qquad p_{20928} = p_{20928} \oplus i_0$$

$$p_{8226} = p_{8226} \oplus i_0$$

(3) for the next 359 information bits $i_m$, $m$ = 1,2,..., 359, accumulate $i_m$ at parity bit addresses {$x + m$ mod 360 * $q$} $mod$ ($n_{ldpc}$ - $k_{ldpc}$), where $x$ denotes the address of the parity bit accumulator corresponding to the first bit $i_0$, and $q$ is a code rate dependent constant (specified in Tables 3a and 3b, below). Continuing with the example for the rate 2/3 code for $n_{ldpc}$ = 64800, $q$ = 60 - so, for example, for information bit $i_1$, the following operations are performed:

$$p_{60} = p_{60} \oplus i_1 \qquad\qquad p_{2827} = p_{2827} \oplus i_1$$

$$p_{10551} = p_{10551} \oplus i_1 \qquad\qquad p_{300} = p_{300} \oplus i_1$$

$$p_{16103} = p_{16103} \oplus i_1 \qquad\qquad p_{18733} = p_{18733} \oplus i_1$$

$$p_{566} = p_{566} \oplus i_1 \qquad\qquad p_{9339} = p_{9339} \oplus i_1$$

$$p_{12886} = p_{12886} \oplus i_1 \qquad\qquad p_{10639} = p_{10639} \oplus i_1$$

$$p_{8125} = p_{8125} \oplus i_1 \qquad\qquad p_{20988} = p_{20988} \oplus i_1$$

$$p_{8286} = p_{8286} \oplus i_1$$

(4) for the 361st information bit $i_{360}$, accumulate $i_{360}$ at the parity bit addresses specified in the second row of the appropriate table (in Annexes B and C of ETSI EN 302 307) table for the respective code rate and FEC Frame size. Then, in a similar manner the addresses of the parity bit accumulators for the following 359 information bits $i_m$, $m$ = 361, 362, ..., 719 are obtained using the **formula** {$x + m$ mod 360 * $q$} $mod$ ($n_{ldpc}$ - $k_{ldpc}$), where $x$ denotes the address of the parity bit accumulator corresponding to the first bit $i_{360}$, (the entries of the second row of the respective table); and (5) in a similar manner, for every group of 360 new information bits, a new row from the respective table is used to find the addresses of the parity bit accumulators.

Then, once all the information bits are exhausted, the final parity bits are obtained by sequentially performing the following operations, starting with $i$ = 1, $p_i = p_i \oplus p_{i-1}$, where $i$ = 1, 2, ... , $n_{idpc}$ - $k_{ldpc}$ - 1, and then the final content of $p_i$, $i$ = 0, 1, ... , $n_{idpc}$ - $k_{ldpc}$ - 1 is equal to the parity bit $p_i$.

Table 3a: $q$ Values (normal FEC Frame - LDPC Coded Block $n_{ldpc}$ = 64800)

| LDPC Code Rate | q |
|---|---|
| 1/4 | 135 |
| 1/3 | 120 |
| 2/5 | 108 |
| 1/2 | 90 |
| 3/5 | 72 |
| 2/3 | 60 |
| 3/4 | 45 |
| 4/5 | 36 |
| 5/6 | 30 |

(continued)

| LDPC Code Rate | q |
|:---:|:---:|
| 8/9 | 20 |
| 9/10 | 18 |

Table 3b: q Values (short FEC Frame - LDPC Coded Block $n_{ldpc}$ = 16200)

| LDPC Code Rate | q |
|:---:|:---:|
| 1/4 | 36 |
| 1/3 | 30 |
| 2/5 | 27 |
| 1/2 | 25 |
| 3/5 | 18 |
| 2/3 | 15 |
| 3/4 | 12 |
| 4/5 | 10 |
| 5/6 | 8 |
| 8/9 | 5 |

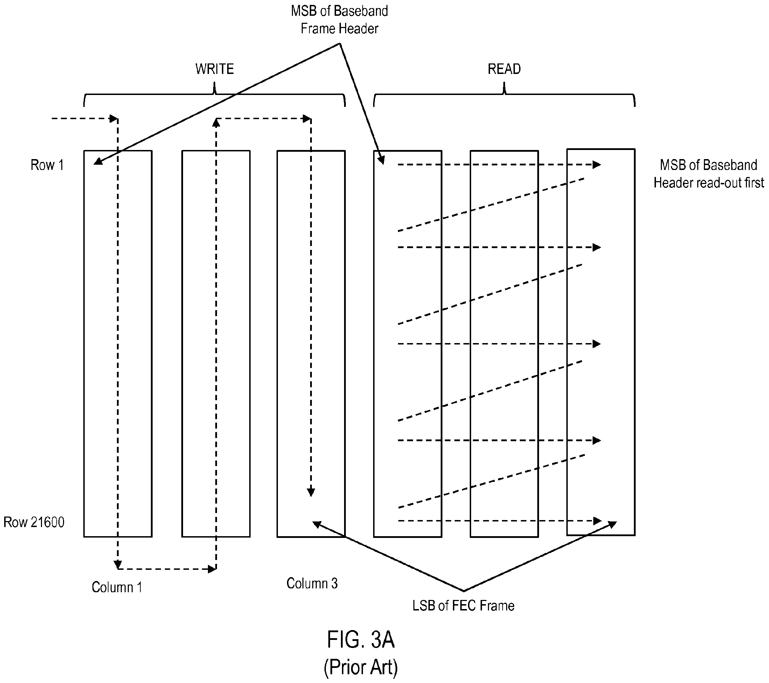

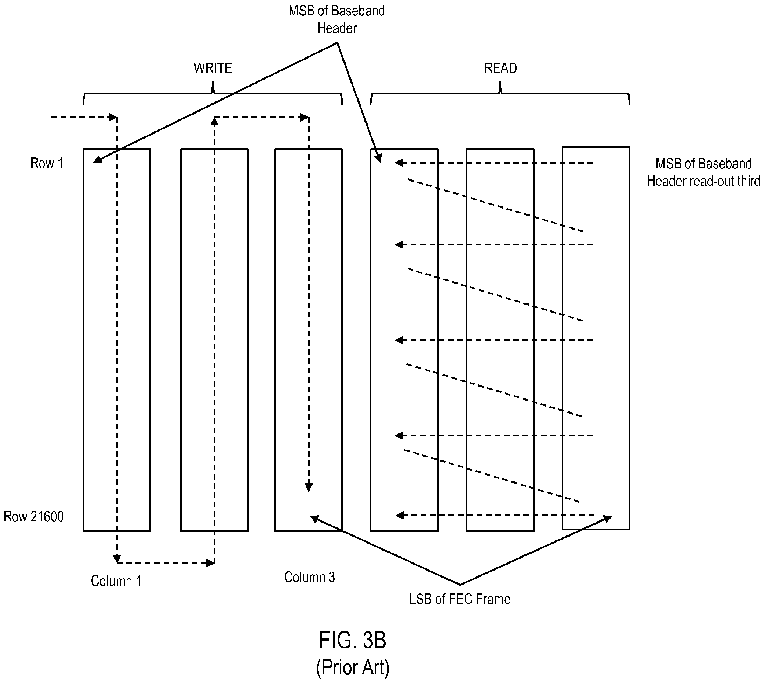

With reference to **FIGs. 3A and 3B**, for the 8PSK, 16APSK and 32APSK modulation schemes of the DVB-S2 standard, the bit interleaver 213c comprises a block interleaver that interleaves the output of the LDPC encoder 213b. Data is serially written into the interleaver column-wise, and serially read out row-wise (the MSB of baseband frame header is read out first, except in the case of the 8PSK rate 3/5 modulation where MSB of the baseband frame header is read out third), as illustrated in **FIGs. 3A and 3B**, respectively. The configuration of the block interleaver for each modulation format is specified in the following table:

Table 4: Block Interleaver Configurations

| Modulation | Rows ($n_{ldpc}$ = 64800) | Rows ($n_{ldpc}$ = 16200) | Columns |
|:---:|:---:|:---:|:---:|
| 8PSK | 21600 | 5400 | 3 |
| 16APSK | 16200 | 4050 | 4 |
| 32APSK | 12960 | 3240 | 5 |

For the DVB-S2 modulation, each FEC Frame (comprising a sequence of 64,800 bits for a normal FEC Frame, or 16,200 bits for a short FEC Frame) is then modulated based on one of various options specified in the standard for modulation of the data payload (e.g., QPSK, 8PSK, 16APSK, or 32APSK). For example, each FEC Frame is serial-to-parallel converted with the following parallelism levels: $\eta_{MOD}$ 2 for QPSK; $\eta_{MOD}$ 3 for 8PSK; $\eta_{MOD}$ 4 for 16APSK; $\eta_{MOD}$ 5 for 32APSK. Then, each resulting parallel sequence is mapped based on a signal constellation, generating an (I, Q) sequence of variable length depending on the selected modulation efficiency ($\eta_{MOD}$ bits/Hz). The DVB-S2 signal constellations for the QPSK, 8PSK, 16APSK, and 32 APSK modulation schemes are illustrated in Figures 9-12 (respectively) of the above-referenced DVB-S2 publication, ETSI EN 302 307. The resulting output sequence is referred to as a complex FEC Frame or XFEC Frame, composed of 64,800/$\eta_{MOD}$(normal XFEC Frame) modulation symbols, or 16,200/$\eta_{MOD}$(short XFEC Frame) modulation symbols. Each modulation symbol thereby comprises a complex vector in the format (I, Q) (I being the in-phase component and Q the quadrature component), or in the equivalent format $\rho$ *exp j*Ø($\rho$ being the modulus of the vector and Ø being its phase).

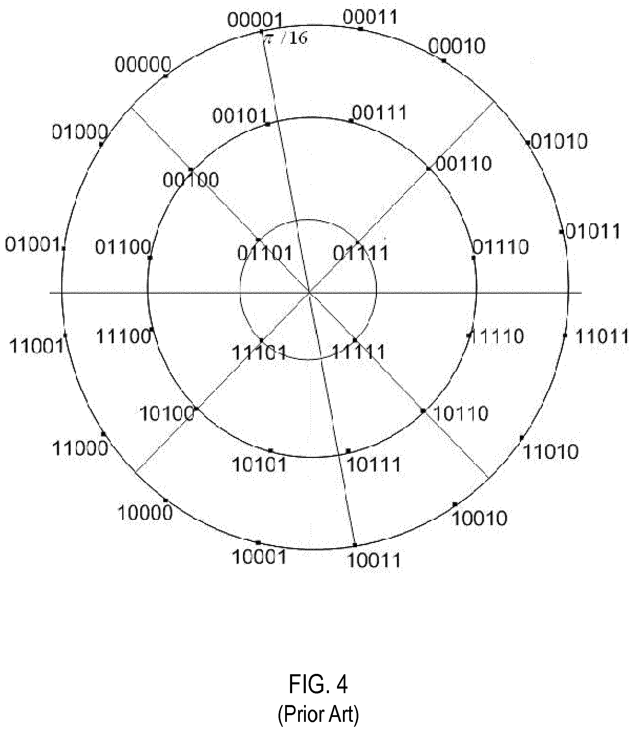

With respect to other current modulation schemes, copending U.S. patent application number 13/327,316, provides a 32APSK constellation. The 32APSK signal constellation is provided with a ring format of 4+12+16 (4 constellation points on the inner-most ring, 12 constellation points on the next outer ring, and 16 constellation points on the outer-most ring). The bit labeling and [x, y] signal point coordinates (where the outer ring is rotated by $\pi$/16 as compared

to the DVB-S2 32APSK constellation) of this 32APSK constellation are as follows (where $\varepsilon_x$ represents average energy per symbol, $4 * R1^2 + 12 * R2^2 + 16 * R3^2 = 32$, and R1 represents the radius of the inner-most ring, R2 represents the radius of the middle ring and R3 represents the radius of the outer ring), as further illustrated in FIG. 4:

| Bit Label | [x, y] Coordinates |
|---|---|
| 00000 | $[-R3 * \sqrt{\varepsilon_x} * \cos(5.0 * \pi/16.0), R3 * \sqrt{\varepsilon_x} * \cos(3.0 * \pi/16.0)]$ |
| 00001 | $[-R3 * \sqrt{\varepsilon_x} * \cos(7.0 * \pi/16.0), R3 * \sqrt{\varepsilon_x} * \cos(\pi/16.0)]$ |
| 00010 | $[R3 * \sqrt{\varepsilon_x} * \cos(5.0 * \pi/16.0), R3 * \sqrt{\varepsilon_x} * \cos(3.0 * \pi/16.0)]$ |
| 00011 | $[R3 * \sqrt{\varepsilon_x} * \cos(7.0 * \pi/16.0), R3 * \sqrt{\varepsilon_x} * \cos(\pi/16.0)]$ |
| 00100 | $[-R2 * \sqrt{\varepsilon_x} * \sin(\pi/4.0), R2 * \sqrt{\varepsilon_x} * \sin(\pi/4.0)]$ |
| 00101 | $[-R2 * \sqrt{\varepsilon_x} * \sin(\pi/12.0), R2 * \sqrt{\varepsilon_x} * \sin(5.0 * \pi/12.0)]$ |
| 00110 | $[R2 * \sqrt{\varepsilon_x} * \sin(\pi/4.0), R2 * \sqrt{\varepsilon_x} * \sin(\pi/4.0)]$ |
| 00111 | $[R2 * \sqrt{\varepsilon_x} * \sin(\pi/12.0), R2 * \sqrt{\varepsilon_x} * \sin(5.0 * \pi/12.0)]$ |
| 01000 | $[-R3 * \sqrt{\varepsilon_x} * \cos(3.0 * \pi/16.0), R3 * \sqrt{\varepsilon_x} * \cos(5.0 * \pi/16.0)]$ |
| 01001 | $[-R3 * \sqrt{\varepsilon_x} * \cos(\pi/16.0), R3 * \sqrt{\varepsilon_x} * \cos(7.0 * \pi/16.0)]$ |
| 01010 | $[R3 * \sqrt{\varepsilon_x} * \cos(3.0 * \pi/16.0), R3 * \sqrt{\varepsilon_x} * \cos(5.0 * \pi/16.0)]$ |
| 01011 | $[R3 * \sqrt{\varepsilon_x} * \cos(\pi/16.0), R3 * \sqrt{\varepsilon_x} * \cos(7.0 * \pi/16.0)]$ |
| 01100 | $[-R2 * \sqrt{\varepsilon_x} * \sin(5.0 * \pi/12.0), R2 * \sqrt{\varepsilon_x} * \sin(\pi/12.0)]$ |
| 01101 | $[-R1 * \sqrt{\varepsilon_x} * \sin(\pi/4.0), R1 * \sqrt{\varepsilon_x} * \sin(\pi/4.0)]$ |
| 01110 | $[R2 * \sqrt{\varepsilon_x} * \sin(5.0 * \pi/12.0), R2 * \sqrt{\varepsilon_x} * \sin(\pi/12.0)]$ |
| 01111 | $[R1 * \sqrt{\varepsilon_x} * \sin(\pi/4.0), R1 * \sqrt{\varepsilon_x} * \sin(\pi/4.0)]$ |
| 10000 | $[-R3 * \sqrt{\varepsilon_x} * \cos(5.0 * \pi/16.0), -R3 * \sqrt{\varepsilon_x} * \cos(3.0 * \pi/16.0)]$ |
| 10001 | $[-R3 * \sqrt{\varepsilon_x} * \cos(7.0 * \pi/16.0), -R3 * \sqrt{\varepsilon_x} * \cos(\pi/16.0)]$ |
| 10010 | $[R3 * \sqrt{\varepsilon_x} * \cos(5.0 * \pi/16.0), -R3 * \sqrt{\varepsilon_x} * \cos(3.0 * \pi/16.0)]$ |
| 10011 | $[R3 * \sqrt{\varepsilon_x} * \cos(7.0 * \pi/16.0), -R3 * \sqrt{\varepsilon_x} * \cos(\pi/16.0)]$ |
| 10100 | $[-R2 * \sqrt{\varepsilon_x} * \sin(\pi/4.0), -R2 * \sqrt{\varepsilon_x} * \sin(\pi/4.0)]$ |
| 10101 | $[-R2 * \sqrt{\varepsilon_x} * \sin(\pi/12.0), -R2 * \sqrt{\varepsilon_x} * \sin(5.0 * \pi/12.0)]$ |

(continued)

| Bit Label | [x, y] Coordinates |
|---|---|
| 10110 | $[R2 * \sqrt{\varepsilon_x} * \sin(\pi/4.0), -R2 * \sqrt{\varepsilon_x} * \sin(\pi/4.0)]$ |
| 10111 | $[R2 * \sqrt{\varepsilon_x} * \sin(\pi/12.0), -R2 * \sqrt{\varepsilon_x} * \sin(5.0 * \pi/12.0)]$ |
| 11000 | $[-R3 * \sqrt{\varepsilon_x} * \cos(3.0 * \pi/16.0), -R3 * \sqrt{\varepsilon_x} * \cos(5.0 * \pi/16.0)]$ |
| 11001 | $[-R3 * \sqrt{\varepsilon_x} * \cos(\pi/16.0), -R3 * \sqrt{\varepsilon_x} * \cos(7.0 * \pi/16.0)]$ |
| 11010 | $[R3 * \sqrt{\varepsilon_x} * \cos(3.0 * \pi/16.0), -R3 * \sqrt{\varepsilon_x} * \cos(5.0 * \pi/16.0)]$ |
| 11011 | $[R3 * \sqrt{\varepsilon_x} * \cos(\pi/16.0), -R3 * \sqrt{\varepsilon_x} * \cos(7.0 * \pi/16.0)]$ |
| 11100 | $[-R2 * \sqrt{\varepsilon_x} * \sin(5.0 * \pi/12.0), -R2 * \sqrt{\varepsilon_x} * \sin(\pi/12.0)]$ |
| 11101 | $[-R1 * \sqrt{\varepsilon_x} * \sin(\pi/4.0), -R1 * \sqrt{\varepsilon_x} * \sin(\pi/4.0)]$ |
| 11110 | $[R2 * \sqrt{\varepsilon_x} * \sin(5.0 * \pi/12.0), -R2 * \sqrt{\varepsilon_x} * \sin(\pi/12.0)]$ |
| 11111 | $[R1 * \sqrt{\varepsilon_x} * \sin(\pi/4.0), -R1 * \sqrt{\varepsilon_x} * \sin(\pi/4.0)]$ |

This 32APSK constellation achieves improved performance over other current 32APSK modulation constellations (e.g., approximately 0.2 dB better performance over the 32APSK constellation of the DVB-S2 standard). Despite the better performance of this constellation, however, to maintain compatibility with the DVB-S2 standard (and preserve the 32APSK modcods thereof), the 32APSK constellation may be applied with only those new codes (and respective code rates), provided pursuant to the exemplary embodiments of the present invention, disclosed herein. As is evident, though, this 32APSK constellation could be applied with other codes (and respective code rates), such as those provided in the DVB-S2 standard.

As specified above, however, current modulation and coding schemes (e.g., the modulation and coding schemes of the DVB-S2 standard) lack support for the operational requirements of terminals at relatively low $E_s/N_0$ ratios (e.g., below approximately -3 dB). Additionally, such current modulation and coding schemes also lack sufficient granularity for terminals within an intermediate $E_s/N_0$ operational range (e.g., from approximately -3 dB to 15.5 dB). Moreover, codes of shorter block sizes are also needed within such operational ranges.

In accordance with exemplary embodiments of the present invention, therefore, modulation and coding schemes are provided that support terminals with operational requirements at relatively low $E_s/N_0$ ratios (e.g., within the range of approximately -3 dB to -10 dB), and that provide finer granularity for terminals with operational requirements within an intermediate operational range (e.g., approximately -3 dB to 15.5 dB). Further, such new modulation and coding schemes are provided with short block lengths. For example, exemplary embodiments provide the following new improved modulation and coding schemes:

Table 5: Modulation and Code Rates

| Modulation | Code Rate |
|---|---|
| $\pi/2$ BPSK, repeat twice | 11/45 |
| QPSK | 11/45 |
| QPSK | 14/45 |
| 8 PSK | 26/45 |
| 16 APSK | 26/45 |

(continued)

| Modulation | Code Rate |
|---|---|
| 8 PSK | 32/45 |
| 16 APSK | 32/45 |
| 32 APSK | 32/45 |
| 16 APSK | 3/5 |
| 32 APSK | 2/3 |

Additionally, with respect to the outer BCH coding of the FEC encoding, in accordance with exemplary embodiments of the present invention, the BCH t-error correcting capabilities are reflected in the following table:

Table 6: BCH t-Error Correction

| Modulation | Code Rate | BCH t-Error Correction |
|---|---|---|
| $\pi/2$ BPSK, repeat twice | 11/45 | 12 |
| QPSK | 11/45 | 12 |
| QPSK | 14/45 | 12 |
| 8 PSK | 26/45 | 12 |
| 16 APSK | 26/45 | 12 |
| 8 PSK | 32/45 | 12 |
| 16 APSK | 32/45 | 12 |
| 32 APSK | 32/45 | 12 |
| 16 APSK | 3/5 | 12 |
| 32 APSK | 2/3 | 12 |

Further, with respect to bit interleaving, exemplary embodiments of the present invention provide improved bit interleaving protocols. As specified above for the DVB-S2 standard, coded bits are written to the interleaver array column-by-column and read out row-by-row from left to right (except for the 8PSK 3/5 modcod - for which the bits are read out right to left). Referring to theses conventions as 0-1-2 for 8PSK, 0-1-2-3 for 16APSK, and 0-1-2-3-4 for 32APSK (and 2-1-0 for the 8PSK 3/5 modcod), according to embodiments of the present invention, the coded bits are similarly written to the interleaver array column-by-column, but are read out based on certain improved orders for the respective new modcods, as listed in the following table:

Table 7: Bit Interleaver Patterns

| Modulation | Code Rate | Bit Interleaver Pattern |
|---|---|---|
| $\pi/2$ BPSK, repeat twice | 11/45 | N/A |
| QPSK | 11/45 | N/A |
| QPSK | 14/45 | N/A |
| 8 PSK | 26/45 | 1-0-2 |
| 16 APSK | 26/45 | 2-1-3-0 |
| 8 PSK | 32/45 | 0-1-2 |
| 16 APSK | 32/45 | 0-1-2-3 |
| 32 APSK | 32/45 | 1-0-4-2-3 |
| 16 APSK | 3/5 | 3-2-0-1 |
| 32 APSK | 2/3 | 4-1-2-3-0 |

With respect to the inner LDPC coding of the FEC encoding, in accordance with exemplary embodiments of the present invention, the respective parity bit accumulator address tables for the respective code rates and FEC Frame lengths are specified in the following parity bit accumulator tables (where, for each code rate $R$, the $q$ values are as follows: $q = (n - k)/360$, (where $n = 16200$ and $k = R * n$)):

Table 8: $q$ Values

| Code Rate | $q$ |
|-----------|-----|
| 11/45 | 34 |
| 14/45 | 31 |
| 26/45 | 19 |
| 32/45 | 13 |
| 3/5 | 18 |
| 2/3 | 15 |

| Table 9a: Address of Parity Bit Accumulators (Rate 11/45) ($n_{ldpc}$=16200) |
|---|
| 9054 9186 12155 1000 7383 6459 2992 4723 8135 11250<br>2624 9237 7139 12238 11962 4361 5292 10967 11036 8105<br>2044 11996 5654 7568 7002 3549 4767 8767 2872 8345<br>6966 8473 5180 8084 3359 5051 9576 5139 1893 902 |
| 3041 3801 8252 11951 909 8535 1038 8400 3200 4585<br>5291 10484 10872<br>442 7516 3720<br>11469 769 10998<br>10575 1436 2935<br>6905 8610 11285<br>1873 5634 6383 |

| Table 9b: Address of Parity Bit Accumulators (Rate 14/45) ($n_{ldpc}$=16200) |
|---|
| 1606 3617 7973 6737 9495 4209 9209 4565 4250 7823 9384 400<br>4105 991 923 3562 3892 10993 5640 8196 6652 4653 9116 7677<br>6348 1341 5445 1494 7799 831 4952 5106 3011 9921 6537 8476<br>7854 5274 8572 3741 5674 11128 4097 1398 5671 7302 8155 2641<br>6548 2103 590 5749 5722 10 2682 1063 633 2949 207 6065<br>2828 6366 4766 399 935 7611 84 150 3146<br>5363 7455 7140<br>9297 482 4848<br>8458 1631 5344<br>5729 6767 4836<br>11019 4463 3882<br>4107 9610 5454<br>11137 4328 6307<br>3260 7897 3809 |

| Table 9c: Address of Parity Bit Accumulators (Rate 26/45) ($n_{ldpc}$=16200) |
|---|
| 6106 5389 698 6749 6294 1653 1984 2167 6139 6095 3832 2468 6115 |

(continued)

| Table 9c: Address of Parity Bit Accumulators (Rate 26/45) ($n_{ldpc}$=16200) |
|---|
| 4202 2362 1852 1264 3564 6345 498 6137 3908 3302 527 2767 6667 |
| 3422 1242 1377 2238 2899 1974 1957 261 3463 4994 215 2338 |
| 3016 5109 6533 2665 5300 4908 4967 5787 726 229 1970 2789 |
| 6146 5765 6649 2871 884 1670 2597 5058 3659 6594 5042 304 |
| 5521 2811 0 4214 2626 2211 1236 3771 852 6356 6797 3463 |
| 1523 1830 3938 5593 2128 5791 3421 3680 6692 1377 3808 3475 |
| 5551 6035 2247 3662 759 6783 116 6380 4586 3367 1 5003 |
| 3518 6557 6510 |
| 1830 839 4421 |
| 5431 5959 6152 |
| 3174 5113 4520 |
| 5399 1303 2496 |
| 2841 741 220 |
| 2731 1830 4193 |
| 1875 3935 223 |
| 9 4720 423 |
| 3107 2676 840 |
| 1950 6177 6457 |
| 409 194 5102 |
| 1907 6050 3455 |
| 714 3 559 |
| 502 4268 4164 |
| 1019 5558 271 |
| 6127 854 3221 |
| 959 5337 2735 |

| Table 9d: Address of Parity Bit Accumulators (Rate 32/45) ($n_{ldpc}$=16200) |
|---|
| 2686 655 2308 1603 336 1743 2778 1263 3555 185 4212 621 |
| 286 2994 2599 2265 126 314 3992 4560 2845 2764 2540 1476 |
| 2670 3599 2900 2281 3597 2768 4423 2805 836 130 1204 4162 |
| 1884 4228 1253 2578 3053 3650 2587 4468 2784 1644 1490 4655 |
| 4258 1699 4363 4555 3810 4046 3806 344 2459 4067 3327 3510 |
| 1021 2741 2528 2168 2820 |
| 254 1080 616 |
| 1465 4192 2972 |
| 2356 2976 1534 |
| 4412 1937 2724 |
| 1430 3024 600 |
| 1952 2136 3573 |
| 3009 3123 1288 |
| 4553 2299 806 |
| 2997 402 4330 |
| 3302 4567 698 |
| 2364 498 3146 |
| 1809 647 992 |
| 3512 32 4301 |
| 1238 251 450 |
| 1657 737 641 |

(continued)

| Table 9d: Address of Parity Bit Accumulators (Rate 32/45) ($n_{ldpc}$=16200) |
|---|
| 560 1720 2893 |
| 1689 2206 902 |
| 3998 1784 2094 |
| 2090 3126 1201 |
| 1565 764 3473 |
| 891 903 2413 |
| 2286 2900 2348 |
| 3026 2033 1502 |
| 2404 1243 556 |
| 308 2222 3825 |
| 1523 3311 389 |

| Table 9e: Address of Parity Bit Accumulators (Rate 3/5) ($n_{ldpc}$=16200) |
|---|
| 2765 5713 6426 3596 1374 4811 2182 544 3394 2840 4310 771 |
| 4951 211 2208 723 1246 2928 398 5739 265 5601 5993 2615 |
| 210 4730 5777 3096 4282 6238 4939 1119 6463 5298 6320 4016 |
| 4167 2063 4757 3157 5664 3956 6045 563 4284 2441 3412 6334 |
| 4201 2428 4474 59 1721 736 2997 428 3807 1513 4732 6195 |
| 2670 3081 5139 3736 1999 5889 4362 3806 4534 5409 6384 5809 |
| 5516 1622 2906 3285 1257 5797 3816 817 875 2311 3543 1205 |
| 4244 2184 5415 1705 5642 4886 2333 287 1848 1121 3595 6022 |
| 2142 2830 4069 5654 1295 2951 3919 1356 884 1786 396 4738 |
| 021612653 |
| 1 1380 1461 |
| 2 2502 3707 |
| 3 3971 1057 |
| 4 5985 6062 |
| 5 1733 6028 |
| 6 3786 1936 |
| 7 4292 956 |
| 8 5692 3417 |
| 9 266 4878 |
| 10 4913 3247 |
| 11 4763 3937 |
| 12 3590 2903 |
| 13 2566 4215 |
| 14 5208 4707 |
| 15 3940 3388 |
| 16 5109 4556 |
| 17 4908 4177 |

| Table 9f: Address of Parity Bit Accumulators (Rate 2/3) ($n_{ldpc}$=16200) |
|---|
| 0 2084 1613 1548 1286 1460 3196 4297 2481 3369 3451 4620 2622 |
| 1 122 1516 3448 2880 1407 1847 3799 3529 373 971 4358 3108 |
| 2 259 3399 929 2650 864 3996 3833 107 5287 164 3125 2350 |
| 3 342 3529 |

(continued)

| Table 9f: Address of Parity Bit Accumulators (Rate 2/3) ($n_{ldpc}$=16200) |
| --- |
| 4 4198 2147 |
| 5 1880 4836 |
| 6 3864 4910 |
| 7 243 1542 |
| 8 3011 1436 |
| 9 2167 2512 |
| 10 4606 1003 |
| 11 2835 705 |
| 12 3426 2365 |
| 13 3848 2474 |
| 14 1360 1743 |
| 0 163 2536 |
| 1 2583 1180 |
| 2 1542 509 |
| 3 4418 1005 |
| 4 5212 5117 |
| 5 2155 2922 |
| 6 347 2696 |
| 7 226 4296 |
| 8 1560 487 |
| 9 3926 1640 |
| 10 149 2928 |
| 11 2364 563 |
| 12 635 688 |
| 13 231 1684 |
| 14 1129 3894 |

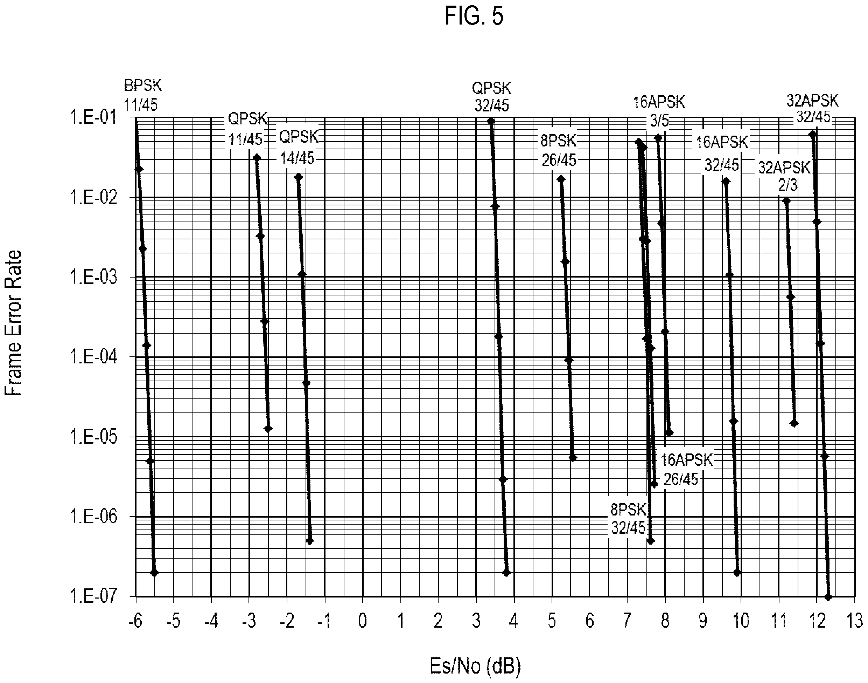

**FIG. 5** illustrates simulated performance curves for the provided modulation and coding schemes (listed above in Table 5) over an AWGN channel, in accordance with exemplary embodiments of the present invention.

**FIG. 6** illustrates a flow chart of the encoding and modulation processes described above, in accordance with exemplary embodiments of the present invention. For example, the encoding and modulation process 600 may be performed by a transmitter 210 as depicted in **FIG. 2A**. With reference to **FIG. 6**, the process starts at step 611, where a source data sequence is received, for example, by the data encapsulation module 211. At step 613, the encapsulation module encapsulates the source data sequence to form a sequence of baseband frames. At step 615, the BCH encoder 213a encodes the baseband frames in accordance with a t-error BCH code to generate respective coded BCH data frames. At step 617, the LDPC encoder 213b encodes the coded BCH data frames in accordance with a structured LDPC code to generate coded LDPC data frames. At step 619, the bit interleaver 213c interleaves the coded bits of the coded LDPC data frames to generate coded FEC frames. At step 621 the modulator 215 modulates the coded FEC frames in accordance with a selected modulation scheme for transmission over the wireless satellite channel 114.

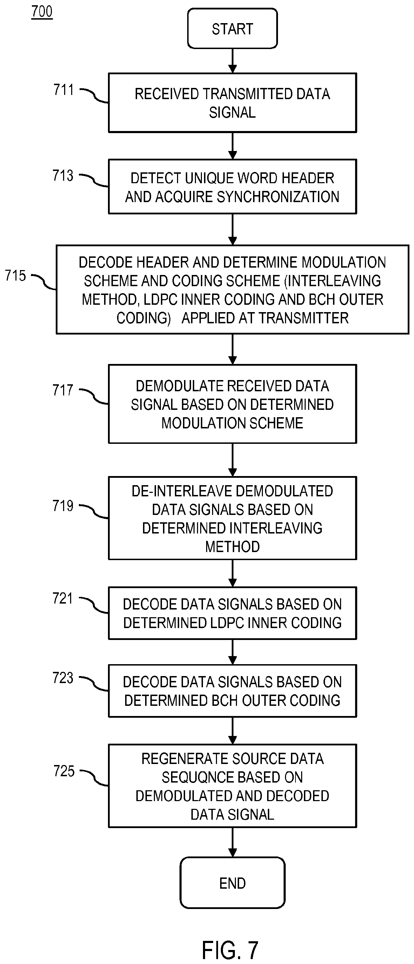

**FIG. 7** illustrates a flow chart of an exemplary process for demodulating and decoding a received data signal transmission to replicate a source data sequence of information bits that was encoded and modulated as described above, in accordance with exemplary embodiments of the present invention. For example, the decoding and demodulation process 700 may be performed by a receiver 220 as depicted in **FIG. 2B**. With reference to **FIG. 7**, the process starts at step 711, where the data signals transmitted over the satellite channel 114 are received by the receiver 220. At step 713, the sync module 227 detects the unique word and acquires synchronization. At step 715, the receiver decodes header information to determine the modulation scheme and coding scheme (e.g., the interleaving method, LDPC inner coding and BCH outer coding applied at the transmitter. The decoding of the header information, for example, may be performed by the sync module 227 or the decoder module 223 (or by another module of the receiver configured to perform such header decoding - not shown in FIG. 2B). At step 717, the demodulator 225 demodulates the received data signals based on the determined modulation scheme to generate a received replica of the transmitted FEC frames. At step 719, the decoder 223 de-interleaves the demodulated data frames based on the determined interleaving method.

At step 721, the decoder 723 decodes the de-interleaved data based on the determined LDPC inner coding. At step 723, the decoder 223 further decodes the data frames based on the determined BCH outer coding. Then at step 725, the data de-encapsulation module de-encapsulates the decoded data frames to generate a replica of the original source data sequence.

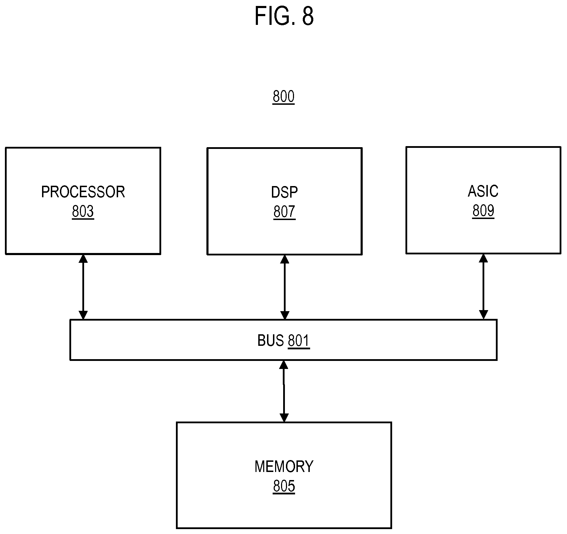

**FIG. 8** illustrates a block diagram of a chip set that can be utilized in implementing communications system protocols, according to exemplary embodiments of the present invention. With reference to **FIG. 8**, chip set 800 includes, for instance, processor and memory components described with respect to FIG. 5 incorporated in one or more physical packages. By way of example, a physical package includes an arrangement of one or more materials, components, and/or wires on a structural assembly (e.g., a baseboard) to provide one or more characteristics such as physical strength, conservation of size, and/or limitation of electrical interaction.

In one embodiment, the chip set 800 includes a communication mechanism such as a bus 801 for passing information among the components of the chip set. A processor 803 has connectivity to the bus 801 to execute instructions and process information stored in, for example, a memory 805. The processor 803 includes one or more processing cores with each core configured to perform independently. A multi-core processor enables multiprocessing within a single physical package. Examples of a multi-core processor include two, four, eight, or greater numbers of processing cores. Alternatively or in addition, the processor 503 includes one or more microprocessors configured in tandem via the bus 801 to enable independent execution of instructions, pipelining, and multithreading. The processor 803 may also be accompanied with one or more specialized components to perform certain processing functions and tasks such as one or more digital signal processors (DSP) 807, and/or one or more application-specific integrated circuits (ASIC) 809. A DSP 807 typically is configured to process real-world signals (e.g., sound) in real time independently of the processor 803. Similarly, an ASIC 809 can be configured to performed specialized functions not easily performed by a general purposed processor. Other specialized components to aid in performing the inventive functions described herein include one or more field programmable gate arrays (FPGA) (not shown), one or more controllers (not shown), or one or more other special-purpose computer chips.

The processor 803 and accompanying components have connectivity to the memory 805 via the bus 801. The memory 805 may comprise various forms of computer-readable media, e.g., including both dynamic memory (e.g., RAM) and static memory (e.g., ROM) for storing executable instructions that, when executed by the processor 803 and/or the DSP 807 and/or the ASIC 809, perform the process of exemplary embodiments as described herein. The memory 805 also stores the data associated with or generated by the execution of the process.

The term "computer-readable medium" or "computer-readable media," as used herein, refers to any medium that participates in providing instructions for execution by the processor 803, and/or one or more of the specialized components, such as the one or more digital signal processors (DSP) 807, and/or one or more application-specific integrated circuits (ASIC) 809. Such a medium may take many forms, including but not limited to non-volatile media, volatile media, and transmission media. Non-volatile media include, for example, read only memory (ROM), included within memory 805. Volatile media, for example, may include dynamic random access memory (RAM), included within memory 805. Transmission media may include copper or other conductive wiring, fiber optics, or other physical transmission media, including the wires and/or optical fiber that comprise bus 801. Transmission media can also take the form of wireless data signals, such as those generated during radio frequency (RF) and infrared (IR) data communications. Common forms of computer-readable media include, for example, magnetic storage media (e.g., magnetic hard disks or any other magnetic storage medium), solid state or semiconductor storage media (e.g., RAM, PROM, EPROM, FLASH EPROM, a data storage device that uses integrated circuit assemblies as memory to store data persistently, or any other storage memory chip or module), optical storage media (e.g., CD ROM, CDRW, DVD, or any other optical storage medium), a or any other medium for storing data from which a computer or processor can read.

Various forms of computer-readable media may be involved in providing instructions to a processor for execution. For example, the instructions for carrying out at least part of the present invention may initially be borne on a magnetic disk of a remote computer. In such a scenario, the remote computer loads the instructions into main memory and sends the instructions over a telephone line using a modem. A modem of a local computer system receives the data on the telephone line and uses an infrared transmitter to convert the data to an infrared signal and transmit the infrared signal to a portable computing device, such as a personal digital assistance (PDA) and a laptop. An infrared detector on the portable computing device receives the information and instructions borne by the infrared signal and places the data on a bus. The bus conveys the data to main memory, from which a processor retrieves and executes the instructions. The instructions received by main memory may optionally be stored on storage device either before or after execution by processor.

Moreover, as will be appreciated, a module or component (as referred to herein) may be composed of software component(s), which are stored in a memory or other computer-readable storage medium, and executed by one or more processors or CPUs of the respective devices. As will also be appreciated, however, a module may alternatively be composed of hardware component(s) or firmware component(s), or a combination of hardware, firmware and/or software components. Further, with respect to the various exemplary embodiments described herein, while certain of the functions are described as being performed by certain components or modules (or combinations thereof), such descriptions are provided as examples and are thus not intended to be limiting. Accordingly, any such functions may be envisioned as being performed by other components or modules (or combinations thereof).

While exemplary embodiments of the present invention may provide for various implementations (e.g., including hardware, firmware and/or software components), and, unless stated otherwise, all functions are performed by a CPU or a processor executing computer executable program code stored in a non-transitory memory or computer-readable storage medium, the various components can be implemented in different configurations of hardware, firmware, software, and/or a combination thereof. Except as otherwise disclosed herein, the various components shown in outline or in block form in the figures are individually well known and their internal construction and operation are not critical either to the making or using of this invention or to a description of the best mode thereof.

**Claims**

1. A method for encoding comprising:

encoding, by a processor of a device, a source data sequence of information bits based on a predetermined structured parity check matrix of a Low Density Parity Check LDPC code, wherein the encoding is performed based on frames of the source data sequence, each frame being of a length of $k_{ldpc}$ information bits $i_0, i_1, ..., i_{k_{ldpc}-1}$, and the output of the encoding comprises coded LDPC frames each being $n_{ldpc}$ coded bits in length, and wherein the structured parity check matrix is represented by tabular information of a format wherein each row represents occurrences of one values within a respective column of the parity check matrix, and the columns of the parity check matrix are derived according to a predetermined operation based on the respective rows of the tabular information, and wherein the tabular information comprises a one of Tables **1a** through **1d** below;

wherein the encoding comprises generating $n_{ldpc}$ - $k_{ldpc}$ parity bits $p_0, p_1, ..., p_{n_{ldpc}-k_{ldpc}-1}$ for each frame of the source data sequence, wherein the generation of the parity bits comprises:

initializing parity bit accumulators for $p_0, p_1, ..., p_{n_{ldpc}-k_{ldpc}-1}$ to zero;

accumulating information bit $i_0$ at parity bit accumulator addresses specified in the first row of the tabular information;

for the next group of $m$ - 1 information bits, $i_y$ with $y$ = 1, 2, ..., $m$ -1, accumulating each information bit at parity bit accumulator addresses $\{x + (y \bmod m) * q\} \bmod (n_{ldpc} - k_{ldpc})$, wherein $x$ denotes an address of a parity bit accumulator corresponding to the information bit $i_0$, and $q$ is a code-rate dependent constant $q = (n_{ldpc} - k_{ldpc})/m$, , and wherein $m$ is a code-dependent constant and $m$ is equal to 360 and $k_{ldpc} = R * n_{idpc}$, where $R$ is the code rate;

accumulating $i_m$ at parity bit accumulator addresses specified in the second row of the table, and, in a similar manner as for the group of m - 1 information bits above, accumulating each information bit of the next group of $m$ - 1 information bits $i_z$, $z$ = $m$+1, $m$+2,..... 2$m$ $m$+1, $m$+2,....,2$m$ at $\{x + (z \bmod m) * q\} \bmod (n_{ldpc} - k_{ldpc})$, wherein $x$ denotes the address of the parity bit accumulator corresponding to the information bit $i_m$ in the entries of the second row of the tabular information;

in a similar manner, for each subsequent group of m information bits, accumulating the information bits at parity bit addresses based on a next row of the tabular information; and

after all of the information bits of the frame are accumulated, performing operations according to $p_i = p_i \oplus p_{i-1}$, wherein for $i$ = 1, 2,..., ($n_{ldpc}$ - $k_{ldpc}$ - 1), each $p_i$ resulting from the operation for a given $i$ is equal to the parity bit $p_i$;

| Table 1a: Address of Parity Bit Accumulators, Rate 11/45, $n_{ldpc}$=16200 |
| --- |
| 9054 9186 12155 1000 7383 6459 2992 4723 8135 11250 |
| 2624 9237 7139 12238 11962 4361 5292 10967 11036 8105 |
| 2044 11996 5654 7568 7002 3549 4767 8767 2872 8345 |
| 6966 8473 5180 8084 3359 5051 9576 5139 1893 902 |
| 3041 3801 8252 11951 909 8535 1038 8400 3200 4585 |
| 5291 10484 10872 |
| 442 7516 3720 |
| 11469 769 10998 |
| 10575 1436 2935 |

(continued)

| Table 1a: Address of Parity Bit Accumulators, Rate 11/45, $n_{ldpc}$=16200 |
|---|
| 6905 8610 11285 |
| 1873 5634 6383 |

| Table 1b: Address of Parity Bit Accumulators, Rate 14/45, $n_{ldpc}$=16200 |
|---|
| 1606 3617 7973 6737 9495 4209 9209 4565 4250 7823 9384 400 |
| 4105 991 923 3562 3892 10993 5640 8196 6652 4653 9116 7677 |
| 6348 1341 5445 1494 7799 8314952 5106 3011 9921 6537 8476 |
| 7854 5274 8572 3741 5674 11128 4097 1398 5671 7302 8155 2641 |
| 6548 2103 590 5749 5722 10 2682 1063 633 2949 207 6065 |
| 2828 6366 4766 399 935 7611 84 150 3146 |
| 5363 7455 7140 |
| 9297 482 4848 |
| 8458 1631 5344 |
| 5729 6767 4836 |
| 11019 4463 3882 |
| 4107 9610 5454 |
| 11137 4328 6307 |
| 3260 7897 3809 |

| Table 1c: Address of Parity Bit Accumulators, Rate 26/45, $n_{ldpc}$=16200 |
|---|
| 6106 5389 698 6749 6294 1653 1984 2167 6139 6095 3832 2468 6115 |
| 4202 2362 1852 1264 3564 6345 498 6137 3908 3302 527 2767 6667 |
| 3422 1242 1377 2238 2899 1974 1957 261 3463 4994 215 2338 |
| 3016 5109 6533 2665 5300 4908 4967 5787 726 229 1970 2789 |
| 6146 5765 6649 2871 884 1670 2597 5058 3659 6594 5042 304 |
| 5521 28110 4214 2626 2211 1236 3771852 6356 6797 3463 |
| 1523 1830 3938 5593 2128 5791 3421 3680 6692 1377 3808 3475 |
| 5551 6035 2247 3662 759 6783 116 6380 4586 3367 1 5003 |
| 3518 6557 6510 |
| 1830 839 4421 |
| 5431 5959 6152 |
| 3174 5113 4520 |
| 5399 1303 2496 |
| 2841 741 220 |
| 2731 1830 4193 |
| 1875 3935 223 |
| 9 4720 423 |
| 3107 2676 840 |
| 1950 6177 6457 |
| 4091 94 5102 |
| 1907 6050 3455 |
| 714 3 559 |
| 502 4268 4164 |
| 1019 5558 271 |
| 6127 854 3221 |
| 959 5337 2735 |

| Table 1d: Address of Parity Bit Accumulators, Rate 32/45, $n_{ldpc}$=16200 |
|---|
| 2686 655 2308 1603 336 1743 2778 1263 3555 185 4212 621 |
| 286 2994 2599 2265 126 314 3992 4560 2845 2764 2540 1476 |
| 2670 3599 2900 2281 3597 2768 4423 2805 836 130 1204 4162 |
| 1884 4228 1253 2578 3053 3650 2587 4468 2784 1644 1490 4655 |
| 4258 1699 4363 4555 3810 4046 3806 344 2459 4067 3327 3510 |
| 1021 2741 2528 2168 2820 |
| 254 1080 616 |
| 1465 4192 2972 |
| 2356 2976 1534 |
| 4412 1937 2724 |
| 1430 3024 600 |
| 1952 2136 3573 |
| 3009 3123 1288 |
| 4553 2299 806 |
| 2997 402 4330 |
| 3302 4567 698 |
| 2364 498 3146 |
| 1809 647 992 |
| 3512 32 4301 |
| 1238 251 450 |
| 1657 737 641 |
| 560 1720 2893 |
| 1689 2206 902 |
| 3998 1784 2094 |
| 2090 3126 1201 |
| 1565 764 3473 |
| 891 903 2413 |
| 2286 2900 2348 |
| 3026 2033 1502 |
| 2404 1243 556 |
| 308 2222 3825 |
| 1523 3311 389 |

2. The method of claim 1, wherein the LDPC code is of a structure that facilitates use of a plurality of parallel engines for decoding the coded frames.

3. The method of any of claims 1 to 2, further comprising:

modulating the coded LDPC frames according to one of the following modulation types: $\pi/2$ BPSK Binary Phase Shift Keying, QPSK Quadrature Phase Shift Keying, 8-PSK Phase Shift Keying, 16-APSK Amplitude Phase Shift Keying, and 32-APSK.

4. The method of any of claims 1 to 3, wherein the source data sequence is segmented into a series of baseband frames, and the method further comprises:

encoding each baseband frame based on a t-error Bose Chaudhuri Hocquenghem BCH code, wherein the BCH encoding is an outer coding and the LDPC encoding is an inner coding.

5. The method of claim 4, further comprising:

interleaving each coded LDPC frame using a block interleaver, wherein the coded bits are written into an interleaver array on a column-by-column basis and read out on a row-by-row basis, and the output of the interleaving comprises coded FEC frames.

6. The method of claim 5, wherein the interleaver array comprises a number of rows and a number of columns, and the coded bits are read out of each row in a predetermined order, and wherein:

the number of columns in the interleaver array is based on a selected modulation scheme as specified in the following table:

| Modulation Scheme | # of Interleaver Array Columns |
|---|---|
| 8PSK | 3 |
| 16APSK | 4 |
| 32APSK | 5 |

; and
the order in which the coded bits are read out of each row of the interleaver array is based on the selected modulation scheme and a selected code rate as specified in the following table, wherein the numbers reflecting the bit interleaver patterns chronologically signify a respective column of the row being read out, with "0" signifying the leftmost column:

| Modulation | Code Rate | Bit Interleaver Pattern |
|---|---|---|
| 8 PSK | 26/45 | 1-0-2 |
| 16 APSK | 26/45 | 2-1-3-0 |
| 8 PSK | 32/45 | 0-1-2 |
| 16 APSK | 32/45 | 0-1-2-3 |
| 32 APSK | 32/45 | 1-0-4-2-3 |

7. The method of claim 6, further comprising:

modulating the coded FEC frames according to the selected modulation scheme, wherein the selected modulation scheme comprises one of the following modulation types: $\pi/2$ BPSK Binary Phase Shift Keying, QPSK Quadrature Phase Shift Keying, 8-PSK Phase Shift Keying, 16-APSK Amplitude Phase Shift Keying, and 32-APSK;
wherein, in the case of $\pi/2$ BPSK or QPSK, the coded FEC frames are not interleaved.

8. An apparatus for enconding, comprising:

at least one processor; and
at least one memory including computer program code for one or more programs,
the at least one memory and the computer program code configured to, with the at least one processor, cause the apparatus to perform at least the following:

encoding, by a processor of a device, a source data sequence of information bits based on a predetermined structured parity check matrix of a Low Density Parity Check LDPC code, wherein the encoding is performed based on frames of the source data sequence, each frame being of a length of $k_{ldpc}$ information bits $i_0, i_1,...,$ $i_{k_{ldpc}-1}$, and the output of the encoding comprises coded LDPC frames each being $n_{ldpc}$ coded bits in length, wherein the structured parity check matrix is represented by tabular information of a format wherein each row represents occurrences of one values within a respective column of the parity check matrix, and the columns of the parity check matrix are derived according to a predetermined operation based on the respective rows of the tabular information, and wherein the tabular information comprises a one of Tables **2a** through **2d** below;

wherein the encoding comprises generating $n_{ldpc} - k_{ldpc}$ parity bits $p_0, p_1,..., p_{nkldpc-kldpc-1}$ for each frame of the source data sequence, wherein the generation of the parity bits comprises:

initializing parity bit accumulators for $p_0, p_1, ..., p_{nldpc-kldpc-1}$ to zero;

accumulating information bit $i_0$ at parity bit accumulator addresses specified in the first row of the tabular information;

for the next group of $m - 1$ information bits, $i_y$ with $y =1, 2,..., m$-1, accumulating each information bit at parity bit accumulator addresses $\{x + (y \bmod m) * q\} \bmod (n_{ldpc} - k_{ldpc})$, wherein $x$ denotes an address of a parity bit accumulator corresponding to the information bit $i_0$, and $q$ is a code-rate dependent constant $q = (n_{ldpc} - k_{ldpc})/m$, and wherein $m$ is a code-dependent constant and m is equal to 360 and $k_{ldpc}$ $R * n_{ldpc}$, wherein $R$ is the code rate;

accumulating $i_m$ at parity bit accumulator addresses specified in the second row of the table, and, in a similar manner as for the group of $m$ -1 information bits above, accumulating each information bit of the next group of $m$ -1 information bits $i_z$, $z=m+1$, $m+2$,..., 2m at $\{x + (z \bmod m) * q\} \bmod (n_{ldpc} - k_{ldpc})$, wherein $x$ denotes the address of the parity bit accumulator corresponding to the information bit $i_m$ in the entries of the second row of the tabular information;

in a similar manner, for each subsequent group of $m$ information bits, accumulating the information bits at parity bit addresses based on a next row of the tabular information; and

after all of the information bits of the frame are accumulated, performing operations according to $p_i = p_i \oplus p_{i-1}$, wherein for $i = 1, 2, ..., (n_{ldpc} - k_{ldpc} - 1)$, each $p_i$ resulting from the operation for a given $i$ is equal to the parity bit $p_i$;

| Table 2a: Address of Parity Bit Accumulators, Rate 11/45, $n_{ldpc}$=16200 |
|---|
| 9054 9186 12155 1000 7383 6459 2992 4723 8135 11250 |
| 2624 9237 7139 12238 11962 4361 5292 10967 11036 8105 |
| 2044 11996 5654 7568 7002 3549 4767 8767 2872 8345 |
| 6966 8473 5180 8084 3359 50519576 5139 1893 902 |
| 3041 3801 8252 11951 909 8535 1038 8400 3200 4585 |
| 5291 10484 10872 |
| 442 7516 3720 |
| 11469 769 10998 |
| 10575 1436 2935 |
| 6905 8610 11285 |
| 1873 5634 6383 |

| Table 2b: Address of Parity Bit Accumulators, Rate 14/45, $n_{ldpc}$=16200 |
|---|
| 1606 3617 7973 6737 9495 4209 9209 4565 4250 7823 9384 400 |
| 4105 991923 3562 3892 10993 5640 8196 6652 4653 9116 7677 |
| 6348 1341 5445 1494 7799 8314952 5106 3011 9921 6537 8476 |
| 7854 5274 8572 3741 5674 11128 4097 1398 56717302 8155 2641 |
| 6548 2103 590 5749 5722 10 2682 1063 633 2949 207 6065 |
| 2828 6366 4766 399 935 7611 84 150 3146 |
| 5363 7455 7140 |
| 9297 482 4848 |
| 8458 1631 5344 |
| 5729 6767 4836 |
| 11019 4463 3882 |
| 4107 9610 5454 |
| 11137 4328 6307 |
| 3260 7897 3809 |

| Table 2c: Address of Parity Bit Accumulators, Rate 26/45, $n_{ldpc}$=16200 |
|---|
| 6106 5389 698 6749 6294 1653 1984 2167 6139 6095 3832 2468 6115 |
| 4202 2362 1852 1264 3564 6345 498 6137 3908 3302 527 2767 6667 |
| 3422 1242 1377 2238 2899 1974 1957 261 3463 4994 215 2338 |
| 3016 5109 6533 2665 5300 4908 4967 5787 726 229 1970 2789 |
| 6146 5765 6649 2871 884 1670 2597 5058 3659 6594 5042 304 |
| 5521 28110 4214 2626 2211 1236 3771 852 6356 6797 3463 |
| 1523 1830 3938 5593 2128 5791 3421 3680 6692 1377 3808 3475 |
| 5551 6035 2247 3662 759 6783 116 6380 4586 3367 1 5003 |
| 3518 6557 6510 |
| 1830 839 4421 |
| 5431 5959 6152 |
| 3174 5113 4520 |
| 5399 1303 2496 |
| 2841 741 220 |
| 2731 1830 4193 |
| 1875 3935 223 |
| 9 4720 423 |
| 3107 2676 840 |
| 1950 6177 6457 |
| 4091 94 5102 |
| 1907 6050 3455 |
| 714 3 559 |
| 502 4268 4164 |
| 1019 5558 271 |
| 6127 854 3221 |
| 959 5337 2735 |

| Table 2d: Address of Parity Bit Accumulators, Rate 32/45, $n_{ldpc}$=16200 |
|---|
| 2686 655 2308 1603 336 1743 2778 1263 3555 185 4212 621 |
| 286 2994 2599 2265 126 314 3992 4560 2845 2764 2540 1476 |
| 2670 3599 2900 2281 3597 2768 4423 2805 836 130 1204 4162 |
| 1884 4228 1253 2578 3053 3650 2587 4468 2784 1644 1490 4655 |
| 4258 1699 4363 4555 3810 4046 3806 344 2459 4067 3327 3510 |
| 1021 2741 2528 2168 2820 |
| 254 1080 616 |
| 1465 4192 2972 |
| 2356 2976 1534 |
| 4412 1937 2724 |
| 1430 3024 600 |
| 1952 2136 3573 |
| 3009 3123 1288 |
| 4553 2299 806 |
| 2997 402 4330 |
| 3302 4567 698 |
| 2364 498 3146 |
| 1809 647 992 |
| 3512 32 4301 |

(continued)

| Table 2d: Address of Parity Bit Accumulators, Rate 32/45, $n_{ldpc}$=16200 |
|---|
| 1238 251450 |
| 1657 737 641 |
| 560 1720 2893 |
| 1689 2206 902 |
| 3998 1784 2094 |
| 2090 3126 1201 |
| 1565 764 3473 |
| 891 903 2413 |
| 2286 2900 2348 |
| 3026 2033 1502 |
| 2404 1243 556 |
| 308 2222 3825 |
| 1523 3311389 |

9. The apparatus of claim 8, wherein the LDPC code is of a structure that facilitates use of a plurality of parallel engines for decoding the coded frames.

10. The apparatus of any of claims 8 to 9, further comprising:

modulating the coded LDPC frames according to one of the following modulation types: π/2 BPSK Binary Phase Shift Keying, QPSK Quadrature Phase Shift Keying, 8-PSK Phase Shift Keying, 16-APSK Amplitude Phase Shift Keying, and 32-APSK.

11. The apparatus of any of claims 8 to 10, , wherein the source data sequence is segmented into a series of baseband frames, and the method further comprises:

encoding each baseband frame based on a t-error Bose Chaudhuri Hocquenghem BCH code, wherein the BCH encoding is an outer coding and the LDPC encoding is an inner coding.

12. The apparatus of claim 11, further comprising:

interleaving each coded LDPC frame using a block interleaver, wherein the coded bits are written into an interleaver array on a column-by-column basis and read out on a row-by-row basis, and the output of the interleaving comprises coded FEC frames.

13. The apparatus of claim 12, wherein the interleaver array comprises a number of rows and a number of columns, and the coded bits are read out of each row in a predetermined order, and wherein:

the number of columns in the interleaver array is based on a selected modulation scheme as specified in the following table:

| Modulation Scheme | # of Interleaver Array Columns |
|---|---|
| 8PSK | 3 |
| 16APSK | 4 |
| 32APSK | 5 |

and
the order in which the coded bits are read out of each row of the interleaver array is based on the selected modulation scheme and a selected code rate as specified in the following table, where the numbers reflecting the bit interleaver patterns chronologically signify a respective column of the row being read out, with "0" signifying the leftmost column:

| Modulation | Code Rate | Bit Interleaver Pattern |
|---|---|---|
| 8 PSK | 26/45 | 1-0-2 |
| 16 APSK | 26/45 | 2-1-3-0 |
| 8 PSK | 32/45 | 0-1-2 |
| 16 APSK | 32/45 | 0-1-2-3 |
| 32 APSK | 32/45 | 1-0-4-2-3 |

**14.** The apparatus of claim 13, further comprising:

modulating the coded FEC frames according to the selected modulation scheme, wherein the selected modulation scheme comprises one of the following modulation types: $\pi/2$ BPSK Binary Phase Shift Keying, QPSK Quadrature Phase Shift Keying, 8-PSK Phase Shift Keying, 16-APSK Amplitude Phase Shift Keying, and 32-APSK;
wherein, in the case of $\pi/2$ BPSK or QPSK, the coded FEC frames are not interleaved.

**15.** Computer program with program code in order to perform all steps of any of claims 1 to 7, when then program runs on a computer or digital signal processor.

**Patentansprüche**

**1.** Verfahren zum Codieren, umfassend:

Codieren einer Quelldatenfolge von Informationsbits mittels eines Prozessors einer Vorrichtung auf der Grundlage einer bestimmten strukturierten Paritätskontrollmatrix eines LDPC-Codes, wobei der LDPC-Code ein Paritätskontroll-Code geringer Dichte ist, wobei das Codieren auf der Grundlage von Rahmen der Quelldatenfolge ausgeführt wird, wobei jeder Rahmen von einer Länge von $k_{ldpc}$ Informationsbits $i_0$, $i_{1,...,}i_{kldpc}$-1 ist und das Ausgangssignal der Codierung codierte LDPC-Rahmen umfasst, die jeweils in der Länge $n_{ldpc}$ codierte Bits aufweisen,
wobei die strukturierte Paritätskontrollmatrix durch eine tabellarische Information eines Formats dargestellt wird, in welchem jede Zeile Auftritte von einen Werten innerhalb einer jeweiligen Spalte der Paritätskontrollmatrix darstellt und die Spalten der Paritätskontrollmatrix entsprechend einer bestimmten Operation auf der Grundlage der jeweiligen Zeilen der tabellarischen Information abgeleitet werden,
wobei die tabellarische Information eine von unten stehenden Tabellen 1a bis 1d umfasst,
wobei die Codierung die Erzeugung von $n_{ldpc}$-$k_{ldpc}$ Paritätsbits $p_0$, $p_1,...,$ $p_{nldpc\text{-}kldpc}$-1 für jeden Rahmen der Quelldatenfolge umfasst, wobei die Erzeugung der Paritätsbits umfasst:

Initialisieren von Paritätsbit-Akkumulatoren für $p_0$, $p_1,...,$ $p_{nldpc\text{-}kldpc}$-1 auf Null,
Akkumulieren des Informationsbits $i_0$ unter den in der ersten Zeile der tabellarischen Information spezifizierten Paritätsbit-Akkumulatoradressen,
für die nächste Gruppe von m - 1 Informationsbits $i_y$, mit y = 1, 2, ..., m - 1, Akkumulieren jedes Informationsbits unter den Paritätsbit-Akkumulatoradressen,
$\{x + (y \bmod m)*q\} \bmod(n_{ldpc} - k_{ldpc})$, worin x eine Adresse eines Paritätsbit-Akkumulators entsprechend dem Informationsbit $i_0$ angibt und q eine coderatenabhängige Konstante q = $(n_{ldpc} - k_{ldpc})$/m ist und worin m eine codeabhängige Konstante ist und m gleich 360 ist und $k_{ldpc}$ = R*$n_{ldpc}$ ist und wobei R die Coderate ist,
Akkumulieren von im unter den in der zweiten Zeile der tabellarischen Information spezifizierten Paritätsbit-Akkumulatoradressen,
und in einer ähnlichen Weise wie für die obige Gruppe von m - 1 Informationsbits Akkumulieren jedes Informationsbit der nächsten Gruppe von m-1 Informationsbits $i_z$, z = m + 1, m + 2,..., 2m, m + 1, m + 2,..., 2m bei $\{x + (z \bmod m)*q\} \bmod(n_{ldpc} - k_{ldpc})$, worin x die Adresse des Paritätsbitakkumulators entsprechend dem Informationsbit $i_m$ in den Einträgen der zweiten Zeile der tabellarischen Information angibt,
in einer ähnlichen Weise für jede nachfolgende Gruppe von m Informationsbits Akkumulieren der Informationsbits unter Paritätsbit-Adressen auf der Grundlage einer nächsten Zeile der tabellarischen Information,

und nachdem sämtliche der Informationsbits des Rahmens akkumuliert sind, Ausführen von Operationen entsprechend $p_i = p_i \oplus p_{i-1}$, worin $i = 1, 2,..., (n_{ldpc} - k_{ldpc} - 1)$ ist, wobei jedes $p_i$, das aus der Operation für ein gegebenes $i$ resultiert, gleich dem Paritätsbit $p_i$ ist;

| Tabelle 1a: Adresse von Paritätsbit-Akkumulatoren (Rate 11/45) ($n_{ldpc}$=16200) |
|---|
| 9054 9186 12155 1000 7383 6459 2992 4723 8135 11250 |
| 2624 9237 7139 12238 11962 4361 5292 10967 11036 8105 |
| 2044 11996 5654 7568 7002 3549 4767 8767 2872 8345 |
| 6966 8473 5180 8084 3359 5051 9576 5139 1893 902 |
| 3041 3801 8252 11951 909 8535 1038 8400 3200 4585 |
| 5291 10484 10872 |
| 442 7516 3720 |
| 11469 769 10998 |
| 10575 1436 2935 |
| 6905 8610 11285 |
| 1873 5634 6383 |

| Tabelle 1b: Adresse von Paritätsbit-Akkumulatoren (Rate 14/45) ($n_{ldpc}$=16200) |
|---|
| 1606 3617 7973 6737 9495 4209 9209 4565 4250 7823 9384 400 |
| 4105 991 923 3562 3892 10993 5640 8196 6652 4653 9116 7677 |
| 6348 1341 5445 1494 7799 831 4952 5106 3011 9921 6537 8476 |
| 7854 5274 8572 3741 5674 11128 4097 1398 5671 7302 8155 2641 |
| 6548 2103 590 5749 5722 10 2682 1063 633 2949 207 6065 |
| 2828 6366 4766 399 935 7611 84 150 3146 |
| 5363 7455 7140 |
| 9297 482 4848 |
| 8458 1631 5344 |
| 5729 6767 4836 |
| 11019 4463 3882 |
| 4107 9610 5454 |
| 11137 4328 6307 |
| 3260 7897 3809 |

| Tabelle 1c: Adresse von Paritätsbit-Akkumulatoren (Rate 26/45) ($n_{ldpc}$=16200) |
|---|
| 6106 5389 698 6749 6294 1653 1984 2167 6139 6095 3832 2468 6115 |
| 4202 2362 1852 1264 3564 6345 498 6137 3908 3302 527 2767 6667 |
| 3422 1242 1377 2238 2899 1974 1957 261 3463 4994 215 2338 |
| 3016 5109 6533 2665 5300 4908 4967 5787 726 229 1970 2789 |
| 6146 5765 6649 2871 884 1670 2597 5058 3659 6594 5042 304 |
| 5521 2811 0 4214 2626 2211 1236 3771 852 6356 6797 3463 |
| 1523 1830 3938 5593 2128 5791 3421 3680 6692 1377 3808 3475 |
| 5551 6035 2247 3662 759 6783 116 6380 4586 3367 1 5003 |
| 3518 6557 6510 |
| 1830 839 4421 |
| 5431 5959 6152 |
| 3174 5113 4520 |
| 5399 1303 2496 |
| 2841 741 220 |

(fortgesetzt)

| Tabelle 1c: Adresse von Paritätsbit-Akkumulatoren (Rate 26/45) ($n_{ldpc}$=16200) |
|---|
| 2731 1830 4193 |
| 1875 3935 223 |
| 9 4720 423 |
| 3107 2676 840 |
| 1950 6177 6457 |
| 4091 94 5102 |
| 1907 6050 3455 |
| 714 3 559 |
| 502 4268 4164 |
| 1019 5558 271 |
| 6127 854 3221 |
| 959 5337 2735 |

| Tabelle 1d: Adresse von Paritätsbit-Akkumulatoren (Rate 32/45) ($n_{ldpc}$=16200) |
|---|
| 2686 655 2308 1603 336 1743 2778 1263 3555 185 4212 621 |
| 286 2994 2599 2265 126 314 3992 4560 2845 2764 2540 1476 |
| 2670 3599 2900 2281 3597 2768 4423 2805 836 130 1204 4162 |
| 1884 4228 1253 2578 3053 3650 2587 4468 2784 1644 1490 4655 |
| 4258 1699 4363 4555 3810 4046 3806 344 2459 4067 3327 3510 |
| 1021 2741 2528 2168 2820 |
| 254 1080 616 |
| 1465 4192 2972 |
| 2356 2976 1534 |
| 4412 1937 2724 |
| 1430 3024 600 |
| 1952 2136 3573 |
| 3009 3123 1288 |
| 4553 2299 806 |
| 2997 402 4330 |
| 3302 4567 698 |
| 2364 498 3146 |
| 1809 647 992 |
| 3512 32 4301 |
| 1238 251 450 |
| 1657 737 641 |
| 560 1720 2893 |
| 1689 2206 902 |
| 3998 1784 2094 |
| 2090 3126 1201 |
| 1565 764 3473 |
| 891 903 2413 |
| 2286 2900 2348 |
| 3026 2033 1502 |
| 2404 1243 556 |
| 308 2222 3825 |
| 1523 3311 389 |

EP 2 802 079 B1

2. Verfahren nach Anspruch 1, wobei der LDPC-Code von einer Struktur ist, welche die Nutzung einer Vielzahl von parallelen Maschinen zur Decodierung der codierten Rahmen erleichtert.

3. Verfahren nach einem der Ansprüche 1 bis 2, ferner umfassend:

Modulieren der codierten LDPC-Rahmen entsprechend einem der folgenden Modulationstypen: n/2-BPSK, wobei BPSK eine binäre Phasenumtastung ist, QPSK, wobei QPSK eine Quadratur-Phasenumtastung ist, 8-PSK, wobei PSK eine Phasenumtastung ist, 16-APSK, wobei APSK eine Amplituden-Phasenumtastung ist, und 32-APSK.

4. Verfahren nach einem der Ansprüche 1 bis 3, wobei die Quelldatenfolge in eine Reihe von Basisbandrahmen segmentiert wird und wobei das Verfahren ferner umfasst:

Codieren jedes Basisbandrahmens auf der Grundlage eines t-Fehler-BCH-Codes, wobei der BCH-Code ein Bose-Chaudhuri-Hocquenghem-Code ist
und wobei die BCH-Codierung eine äußere Codierung ist und die LDPC-Codierung eine innere Codierung ist.

5. Verfahren nach Anspruch 4, ferner umfassend:

ein Verschachteln jedes codierten LDPC-Rahmens unter Heranziehung einer Block-Verschachtelungseinrichtung, wobei die codierten Bits in ein Verschachtelungs-Array auf einer spaltenweisen Grundlage geschrieben und auf einer zeilenweisen Grundlage ausgelesen werden und wobei das Ausgangssignal der Verschachtelung codierte FEC-Rahmen umfasst.

6. Verfahren nach Anspruch 5, wobei das Verschachtelungs-Array eine Anzahl von Zeilen und eine Anzahl von Spalten umfasst, wobei die codierten Bits aus jeder Zeile in einer bestimmten Reihenfolge ausgelesen werden
und wobei die Anzahl von Spalten in dem Verschachtelungs-Array auf einem ausgewählten Modulationssystem basiert, wie es in der folgenden Tabelle spezifiziert ist:

| Modulationssystem | # der Verschachtelungs-Anordnungsspalten |
|---|---|
| 8PSK | 3 |
| 16APSK | 4 |
| 32APSK | 5 |

und wobei die Reihenfolge, in der die codierten Bits aus jeder Zeile des Verschachtelungs-Arrays ausgelesen werden, auf dem ausgewählten Modulationssystem und einer ausgewählten Coderate basiert, wie sie in der folgenden Tabelle spezifiziert ist, wobei die die Bit-Verschachtelungsmuster wiedergebenden Zahlen chronologisch eine jeweilige Spalte der ausgelesenen Zeile bezeichnen, wobei "0" die am weitesten links stehende Spalte bezeichnet:

| Modulation | Coderate | Bit-Verschachtelungsmuster |
|---|---|---|
| 8 PSK | 26/45 | 1-0-2 |
| 16 APSK | 26/45 | 2-1-3-0 |
| 8 PSK | 32/45 | 0-1-2 |
| 16 APSK | 32/45 | 0-1-2-3 |
| 32 APSK | 32/45 | 1-0-4-2-3 |

7. Verfahren nach Anspruch 6, ferner umfassend:

Modulieren der codierten FEC-Rahmen gemäß dem ausgewählten Modulationssystem,
wobei das ausgewählte Modulationssystem eine der folgenden Modulationsarten umfasst:

n/2-BPSK, wobei BPSK eine binäre Phasenumtastung ist, QPSK,

wobei QPSK eine Quadratur-Phasenumtastung ist, 8-PSK, wobei PSK eine Phasenumtastung ist, 16-APSK, wobei APSK eine Amplituden-Phasenumtastung ist, und 32-APSK,

wobei die codierten FEC-Rahmen im Falle von n/2-BPSK oder QPSK nicht verschachtelt sind.

8. Vorrichtung zum Codieren, umfassend zumindest einen Prozessor und zumindest einen Speicher, der einen Computerprogrammcode für ein oder mehrere Programme enthält,

wobei der zumindest eine Speicher und der Computerprogrammcode konfiguriert sind, um mit dem zumindest einen Prozessor die Vorrichtung zu veranlassen, zumindest folgendes auszuführen:

Codieren einer Quelldatenfolge von Informationsbits durch einen Prozessor einer Vorrichtung auf der Grundlage einer bestimmten strukturierten Paritätskontrollmatrix eines LDPC-Codes, wobei der LDPC-Code ein Paritätskontrollcode geringer Dichte ist, wobei die Codierung auf der Grundlage von Rahmen der Quelldatenfolge ausgeführt wird,

wobei jeder Rahmen von einer Länge von $k_{ldpc}$ Informationsbits $i_0, i_1,..., i_{k_{ldpc}-1}$ ist und das Ausgangssignal der Codierung codierte LDPC-Rahmen jeweils mit $n_{ldpc}$ codierten Bits in der Länge umfasst,

wobei die strukturierte Paritätskontrollmatrix durch eine tabellarische Information eines Formats dargestellt ist, in welchem jede Zeile Auftritte von einen Werten innerhalb einer jeweiligen Spalte der Paritätskontrollmatrix darstellt und die Spalten der Paritätskontrollmatrix entsprechend einer bestimmten Operation auf der Grundlage der jeweiligen Zeilen der tabellenartigen Information abgeleitet sind und wobei die tabellarische Information eine von unten stehenden Tabellen 2a bis 2d umfasst,

wobei die Codierung die Erzeugung von $n_{ldpc}$ - $k_{ldpc}$ Paritätsbits $p_0, p_1,..., p_{n_{ldpc}-k_{ldpc}-1}$ für jeden Rahmen der Quelldatenfolge umfasst, wobei die Erzeugung der Paritätsbits umfasst:

Initialisieren von Paritätsbit-Akkumulatoren für $p_0, p_1,..., p_{n_{ldpc}-k_{ldpc}-1}$ auf Null,

Akkumulieren des Informationsbits $i_0$ unter den in der ersten Zeile der tabellarischen Information spezifizierten Paritätsbit-Akkumulatoradressen,

für die nächste Gruppe von m - 1 Informationsbits $i_y$, mit y = 1, 2, ..., m - 1, Akkumulieren jedes Informationsbits unter den Paritätsbit-Akkumulatoradressen {x + (y mod m)*q}mod($n_{ldpc}$ - $k_{ldpc}$), worin x eine Adresse eines Paritätsbit-Akkumulators entsprechend dem Informationsbit $i_0$ angibt und q eine coderatenabhängige Konstante mit q = ($n_{ldpc}$ - $k_{ldpc}$) /m ist und worin m eine codeabhängige Konstante ist, die gleich 360 ist, und $k_{ldpc}$ = R*$n_{ldpc}$ ist, wobei R die Coderate ist,

Akkumulieren von im unter den in der zweiten Zeile der Tabelle spezifizierten Akkumulatoradressen,

und in einer ähnlichen Weise wie für die Gruppe von m - 1 Informationsbits oben, Akkumulieren jedes Informationsbits der nächsten Gruppe von m - 1 Informationsbits $i_z$, z = m + 1, m + 2,..., 2m bei {x + (z mod m)*q}mod ($n_{ldpc}$ - $k_{ldpc}$), worin x die Adresse des Paritätsbitakkumulators entsprechend dem Informationsbit $i_m$ in den Einträgen der zweiten Zeile der tabellarischen Information angibt,

in einer ähnlichen Weise für jede nachfolgende Gruppe von m Informationsbits Akkumulieren der Informationsbits unter den Paritätsbit-Adressen auf der Grundlage einer nächsten Zeile der tabellarischen Information,

und nachdem sämtliche der Informationsbits des Rahmens akkumuliert sind, Ausführen von Operationen entsprechend $p_i = p_i \oplus p_{i-1}$, wobei für i = 1,2,..., ($n_{ldpc}$ - $k_{ldpc}$ - 1) jedes $p_i$, das aus der Operation für ein gegebenes i resultiert, gleich dem Paritätsbit $p_i$ ist;

| Tabelle 2a: Adresse von Paritätsbit-Akkumulatoren (Rate 11/45) ($n_{ldpc}$=16200) |
|---|
| 9054 9186 12155 1000 7383 6459 2992 4723 8135 11250 |
| 2624 9237 7139 12238 11962 4361 5292 10967 11036 8105 |
| 2044 11996 5654 7568 7002 3549 4767 8767 2872 8345 |
| 6966 8473 5180 8084 3359 5051 9576 5139 1893 902 |
| 3041 3801 8252 11951 909 8535 1038 8400 3200 4585 |
| 5291 10484 10872 |
| 442 7516 3720 |
| 11469 769 10998 |
| 10575 1436 2935 |
| 6905 8610 11285 |
| 1873 5634 6383 |

| Tabelle 2b: Adresse von Paritätsbit-Akkumulatoren (Rate 14/45) ($n_{ldpc}$=16200) |
| --- |
| 1606 3617 7973 6737 9495 4209 9209 4565 4250 7823 9384 400 |
| 4105 991 923 3562 3892 10993 5640 8196 6652 4653 9116 7677 |
| 6348 1341 5445 1494 7799 831 4952 5106 3011 9921 6537 8476 |
| 7854 5274 8572 3741 5674 11128 4097 1398 5671 7302 8155 2641 |
| 6548 2103 590 5749 5722 10 2682 1063 633 2949 207 6065 |
| 2828 6366 4766 399 935 7611 84 150 3146 |
| 5363 7455 7140 |
| 9297 482 4848 |
| 8458 1631 5344 |
| 5729 6767 4836 |
| 11019 4463 3882 |
| 4107 9610 5454 |
| 11137 4328 6307 |
| 3260 7897 3809 |

| Tabelle 2c: Adresse von Paritätsbit-Akkumulatoren (Rate 26/45) ($n_{ldpc}$=16200) |
| --- |
| 6106 5389 698 6749 6294 1653 1984 2167 6139 6095 3832 2468 6115 |
| 4202 2362 1852 1264 3564 6345 498 6137 3908 3302 527 2767 6667 |
| 3422 1242 1377 2238 2899 1974 1957 261 3463 4994 215 2338 |
| 3016 5109 6533 2665 5300 4908 4967 5787 726 229 1970 2789 |
| 6146 5765 6649 2871 884 1670 2597 5058 3659 6594 5042 304 |
| 5521 2811 0 4214 2626 2211 1236 3771 852 6356 6797 3463 |
| 1523 1830 3938 5593 2128 5791 3421 3680 6692 1377 3808 3475 |
| 5551 6035 2247 3662 759 6783 116 6380 4586 3367 1 5003 |
| 3518 6557 6510 |
| 1830 839 4421 |
| 5431 5959 6152 |
| 3174 5113 4520 |
| 5399 1303 2496 |
| 2841 741 220 |
| 2731 1830 4193 |
| 1875 3935 223 |
| 9 4720 423 |
| 3107 2676 840 |
| 1950 6177 6457 |
| 4091 94 5102 |
| 1907 6050 3455 |
| 714 3 559 |
| 502 4268 4164 |
| 1019 5558 271 |
| 6127 854 3221 |
| 959 5337 2735 |

| Tabelle 2d: Adresse von Paritätsbit-Akkumulatoren (Rate 32/45) ($n_{ldpc}$=16200) |
| --- |
| 2686 655 2308 1603 336 1743 2778 1263 3555 185 4212 621 |

(fortgesetzt)

| Tabelle 2d: Adresse von Paritätsbit-Akkumulatoren (Rate 32/45) ($n_{ldpc}$=16200) |
| --- |
| 286 2994 2599 2265 126 314 3992 4560 2845 2764 2540 1476 |
| 2670 3599 2900 2281 3597 2768 4423 2805 836 130 1204 4162 |
| 1884 4228 1253 2578 3053 3650 2587 4468 2784 1644 1490 4655 |
| 4258 1699 4363 4555 3810 4046 3806 344 2459 4067 3327 3510 |
| 1021 2741 2528 2168 2820 |
| 254 1080 616 |
| 1465 4192 2972 |
| 2356 2976 1534 |
| 4412 1937 2724 |
| 1430 3024 600 |
| 1952 2136 3573 |
| 3009 3123 1288 |
| 4553 2299 806 |
| 2997 402 4330 |
| 3302 4567 698 |
| 2364 498 3146 |
| 1809 647 992 |
| 3512 32 4301 |
| 1238 251 450 |
| 1657 737 641 |
| 560 1720 2893 |
| 1689 2206 902 |
| 3998 1784 2094 |
| 2090 3126 1201 |
| 1565 764 3473 |
| 891 903 2413 |
| 2286 2900 2348 |
| 3026 2033 1502 |
| 2404 1243 556 |
| 308 2222 3825 |
| 1523 3311 389 |

9. Vorrichtung nach Anspruch 8, wobei der LDPC-Code von einer Struktur ist, welche die Nutzung einer Vielzahl von parallelen Maschinen zur Decodierung der codierten Rahmen erleichtert.

10. Vorrichtung nach einem der Ansprüche 8 bis 9, ferner umfassend:

Modulieren der codierten LDPC-Rahmen entsprechend einem der folgenden Modulationstypen: n/2-BPSK, wobei BPSK eine binäre Phasenumtastung ist, QPSK, wobei QPSK eine Quadratur-Phasenumtastung ist, 8-PSK, wobei PSK eine Phasenumtastung ist, 16-APSK, wobei APSK eine Amplituden-Phasenumtastung ist, und 32-APSK.

11. Vorrichtung nach einem der Ansprüche 8 bis 10, wobei die Quelldatenfolge in eine Reihe von Basisbandrahmen segmentiert ist und wobei das Verfahren der Vorrichtung ferner umfasst:

Codieren jedes Basisbandrahmens auf der Grundlage eines t-Fehler-BCH-Codes, wobei der BCH-Code ein Bose-Chaudhuri-Hocquenghem-Code ist,
und wobei die BCH-Codierung eine äußere Codierung ist und die LDPC-Codierung eine innere Codierung ist.

12. Vorrichtung nach Anspruch 11, ferner umfassend:

ein Verschachteln jedes codierten LDPC-Rahmens unter Heranziehung einer Block-Verschachtelungseinrichtung, wobei die codierten Bits in ein Verschachtelungs-Array auf einer spaltenweisen Grundlage geschrieben und auf einer zeilenweisen Grundlage ausgelesen werden und wobei das Ausgangssignal der Verschachtelung codierte FEC-Rahmen umfasst.

**13.** Vorrichtung nach Anspruch 12, wobei das Verschachtelungs-Array eine Anzahl von Zeilen und eine Anzahl von Spalten umfasst,

wobei die codierten Bits aus jeder Zeile in einer bestimmten Reihenfolge ausgelesen werden

und wobei die Anzahl von Spalten in dem Verschachtelungs-Array auf einem ausgewählten Modulationssystem basiert, wie es in der folgenden Tabelle spezifiziert ist:

| Modulationssystem | # der Verschachtelungs-Anordnungsspalten |
|---|---|
| 8PSK | 3 |
| 16APSK | 4 |
| 32APSK | 5 |

und wobei die Reihenfolge, in der die codierten Bits aus jeder Zeile des Verschachtelungs-Arrays ausgelesen werden, auf dem ausgewählten Modulationssystem und einer ausgewählten Coderate basiert, wie sie in der folgenden Tabelle spezifiziert ist, wobei die die Bit-Verschachtelungsmuster wiedergebenden Zahlen chronologisch eine jeweilige Spalte der ausgelesenen Zeile bezeichnen, wobei "0" die am weitesten links stehende Spalte bezeichnet:

| Modulation | Coderate | Bit-Verschachtelungsmuster |
|---|---|---|
| 8 PSK | 26/45 | 1-0-2 |
| 16 APSK | 26/45 | 2-1-3-0 |
| 8 PSK | 32/45 | 0-1-2 |
| 16 APSK | 32/45 | 0-1-2-3 |
| 32 APSK | 32/45 | 1-0-4-2-3 |

**14.** Vorrichtung nach Anspruch 13, ferner umfassend:

Modulieren der codierten FEC-Rahmen gemäß dem ausgewählten Modulationssystem,
wobei das ausgewählte Modulationssystem eine der folgenden Modulationsarten umfasst:

n/2-BPSK, wobei BPSK eine binäre Phasenumtastung ist, QPSK,
wobei QPSK eine Quadratur-Phasenumtastung ist, 8-PSK, wobei PSK eine Phasenumtastung ist, 16-APSK, wobei APSK eine Amplituden-Phasenumtastung ist, und 32-APSK,
wobei die codierten FEC-Rahmen im Falle von n/2-BPSK oder QPSK nicht verschachtelt sind.

**15.** Computerprogramm mit einem Programmcode, um sämtliche Schritte nach einem der Ansprüche 1 bis 7 auszuführen, wenn das Programm in einem Computer oder einem digitalen Signalprozessor abläuft.

**Revendications**

**1.** Procédé pour l'encodage comprenant :

l'encodage, par un processeur d'un dispositif, d'une séquence de données source de bits d'information sur la base d'une matrice de contrôle de parité structurée prédéterminée d'un code de Contrôle de parité de faible densité LDPC, dans lequel l'encodage est effectué sur la base de trames de la séquence de données source, chaque trame étant d'une longueur de $k_{ldpc}$ bits d'information $i_0, i_1,..., i_{k_{ldpc}-1}$, et la sortie de l'encodage comprend des trames LDPC codées chacune ayant une longueur de $n_{ldpc}$ bits codés, et

dans lequel la matrice de contrôle de parité structurée est représentée par des informations tabulaires d'un format dans lequel chaque ligne représente des occurrences de valeurs un à l'intérieur d'une colonne respective de la matrice de contrôle de parité, et les colonnes de la matrice de contrôle de parité sont dérivées selon une opération prédéterminée basée sur les lignes respectives des informations tabulaires, et où les informations tabulaires comprennent une des Tables **1a** à **1d** ci-dessous ;

dans lequel l'encodage comprend la génération de $n_{ldpc}$ - $k_{ldpc}$ bits de parité $p_0$, $p_1$,..., $p_{n_{ldpc}-k_{ldpc}-1}$ pour chaque trame de la séquence de données source, où la génération des bits de parité comprend :

l'initialisation d'accumulateurs de bits de parité pour $p_0$, $p_1$,..., $p_{n_{ldpc}-k_{ldpc}-1}$ à zéro ;

l'accumulation de bit d'information $i_0$ à des adresses d'accumulateur de bits de parité spécifiées dans la première ligne des informations tabulaires ;

pour le groupe suivant de $m$ - 1 bits d'information, $i_y$ avec $y$=1,2,...,$m$-1, l'accumulation de chaque bit d'information à des adresses d'accumulateur de bits de parité $\{x + (y \bmod m) * q\} \bmod (n_{ldpc} - k_{ldpc})$, où $x$ désigne une adresse d'un accumulateur de bits de parité correspondant au bit d'information $i_0$, et $q$ est une constante dépendante du débit de code $q = (n_{ldpc} - k_{ldpc})/m$, et où $m$ est une constante dépendante du débit de code et m est égale à 360 et $k_{ldpc} = R * n_{ldpc}$, où $R$ est le débit de code ;

l'accumulation d'$i_m$ à des adresses d'accumulateur de bits de parité spécifiées dans la seconde ligne de la table, et, d'une manière similaire à celle pour le groupe de $m$ - 1 bits d'information ci-dessus, l'accumulation de chaque bit d'information du groupe suivant de $m$ - 1 bits d'information $i_z$,$z = m + 1$, $m + 2$,...., $2m$ $m + 1$, $m + 2$, ...., $2m$ à $\{x + (z \bmod m) * q\} \bmod (n_{ldpc} - k_{ldpc})$, où $x$ désigne l'adresse de l'accumulateur de bits de parité correspondant au bit d'information $i_m$ dans les entrées de la seconde ligne des informations tabulaires ;

de manière similaire, pour chaque groupe subséquent de $m$ bits d'information, l'accumulation des bits d'information à des adresses de bit de parité sur la base d'une ligne suivante des informations tabulaires ; et

après que la totalité des bits d'information de la trame sont accumulés, l'exécution d'opérations selon $p_i = p_i \oplus p_{i-1}$, où pour $i = 1, 2, ..., (n_{ldpc} - k_{ldpc} - 1)$. chaque $p_i$ résultant de l'opération pour un $i$ donné est égal au bit de parité $p_i$ ;

| Table 1a : Adresse d'Accumulateurs de bits de parité, Débit 11/45, $n_{ldpc}$=16200 |
|---|
| 9054 9186 12155 1000 7383 6459 2992 4723 8135 11250 |
| 2624 9237 7139 12238 11962 4361 5292 10967 11036 8105 |
| 2044 11996 5654 7568 7002 3549 4767 8767 2872 8345 |
| 6966 8473 5180 8084 3359 5051 9576 5139 1893 902 |
| 3041 3801 8252 11951 909 8535 1038 8400 3200 4585 |
| 5291 10484 10872 |
| 442 7516 3720 |
| 11469 769 10998 |
| 10575 1436 2935 |
| 6905 8610 11285 |
| 1873 5634 6383 |

| Table 1b : Adresse d'Accumulateurs de bits de parité, Débit 14/45, $n_{ldpc}$=16200 |
|---|
| 1606 3617 7973 6737 9495 4209 9209 4565 4250 7823 9384 400 |
| 4105 991 923 3562 3892 10993 5640 8196 6652 4653 9116 7677 |
| 6348 1341 5445 1494 7799 831 4952 5106 3011 9921 6537 8476 |
| 7854 5274 8572 3741 5674 11128 4097 1398 5671 7302 8155 2641 |
| 6548 2103 590 5749 5722 10 2682 1063 633 2949 207 6065 |
| 2828 6366 4766 399 935 7611 84 150 3146 |
| 5363 7455 7140 |
| 9297 482 4848 |
| 8458 1631 5344 |
| 5729 6767 4836 |

(suite)

| Table 1b : Adresse d'Accumulateurs de bits de parité, Débit 14/45, $n_{ldpc}$=16200 |
|---|
| 11019 4463 3882 |
| 4107 9610 5454 |
| 11137 4328 6307 |
| 3260 7897 3809 |

| Table 1c : Adresse d'Accumulateurs de bits de parité, Débit 26/45, $n_{ldpc}$=16200 |
|---|
| 6106 5389 698 6749 6294 1653 1984 2167 6139 6095 3832 2468 6115 |
| 4202 2362 1852 1264 3564 6345 498 6137 3908 3302 527 2767 6667 |
| 3422 1242 1377 2238 2899 1974 1957 261 3463 4994 215 2338 |
| 3016 5109 6533 2665 5300 4908 4967 5787 726 229 1970 2789 |
| 6146 5765 6649 2871 884 1670 2597 5058 3659 6594 5042 304 |
| 5521 2811 0 4214 2626 2211 1236 3771 852 6356 6797 3463 |
| 1523 1830 3938 5593 2128 5791 3421 3680 6692 1377 3808 3475 |
| 5551 6035 2247 3662 759 6783 116 6380 4586 3367 1 5003 |
| 3518 6557 6510 |
| 1830 839 4421 |
| 5431 5959 6152 |
| 3174 5113 4520 |
| 5399 1303 2496 |
| 2841 741 220 |
| 2731 1830 4193 |
| 1875 3935 223 |
| 9 4720 423 |
| 3107 2676 840 |
| 1950 6177 6457 |
| 4091 94 5102 |
| 1907 6050 3455 |
| 714 3 559 |
| 502 4268 4164 |
| 1019 5558 271 |
| 6127 854 3221 |
| 959 5337 2735 |

| Table 1d : Adresse d'Accumulateurs de bits de parité, Débit 32/45, $n_{ldpc}$=16200 |
|---|
| 2686 655 2308 1603 336 1743 2778 1263 3555 185 4212 621 |
| 286 2994 2599 2265 126 314 3992 4560 2845 2764 2540 1476 |
| 2670 3599 2900 2281 3597 2768 4423 2805 836 130 1204 4162 |
| 1884 4228 1253 2578 3053 3650 2587 4468 2784 1644 1490 4655 |
| 4258 1699 4363 4555 3810 4046 3806 344 2459 4067 3327 3510 |
| 1021 2741 2528 2168 2820 |
| 254 1080 616 |
| 1465 4192 2972 |
| 2356 2976 1534 |
| 4412 1937 2724 |
| 1430 3024 600 |

(suite)

| Table 1d : Adresse d'Accumulateurs de bits de parité, Débit 32/45, $n_{ldpc}$=16200 |
| --- |
| 1952 2136 3573 |
| 3009 3123 1288 |
| 4553 2299 806 |
| 2997 402 4330 |
| 3302 4567 698 |
| 2364 498 3146 |
| 1809 647 992 |
| 3512 32 4301 |
| 1238 251 450 |
| 1657 737 641 |
| 560 1720 2893 |
| 1689 2206 902 |
| 3998 1784 2094 |
| 2090 3126 1201 |
| 1565 764 3473 |
| 891 903 2413 |
| 2286 2900 2348 |
| 3026 2033 1502 |
| 2404 1243 556 |
| 308 2222 3825 |
| 1523 3311 389 |

**2.** Procédé selon la revendication 1, dans lequel le code LDPC est d'une structure qui facilite l'utilisation d'une pluralité de moteurs parallèles pour décoder les trames codées.

**3.** Procédé selon l'une quelconque des revendications 1 à 2, comprenant en outre :

la modulation des trames LDPC codées selon un des types de modulation suivants : Modulation par déplacement de phase binaire $\pi/2$ BPSK, Modulation par déplacement de phase en quadrature QPSK, Modulation par déplacement de phase 8-PSK, Modulation par déplacement d'amplitude et de phase 16-APSK, et 32-APSK.

**4.** Procédé selon l'une quelconque des revendications 1 à 3, dans lequel la séquence de données source est segmentée en une série de trames de bande de base, et le procédé comprend en outre :

l'encodage de chaque trame de bande de base sur la base d'un code Bose Chaudhuri Hocquenghem BCH d'erreur-t, où l'encodage BCH est un codage externe et l'encodage LDPC est un codage interne.

**5.** Procédé selon la revendication 4, comprenant en outre :

l'entrelacement de chaque trame LDPC codée en utilisant un entrelaceur de blocs, où les bits codés sont écrits dans une matrice d'entrelaceur sur une base colonne-par-colonne et sortis en lecture sur une base ligne-par-ligne, et la sortie de l'entrelacement comprend des trames FEC codées.

**6.** Procédé selon la revendication 5, dans lequel la matrice d'entrelaceur comprend un nombre de lignes et un nombre de colonnes, et les bits codés sont sortis en lecture de chaque ligne dans un ordre prédéterminé, et dans lequel :

le nombre de colonnes dans la matrice d'entrelaceur est basé sur un schéma de modulation sélectionné comme spécifié dans la table suivante :

| Schéma de modulation | # de colonnes de matrice d'entrelaceur |
| --- | --- |
| 8PSK | 3 |

(suite)

| Schéma de modulation | # de colonnes de matrice d'entrelaceur |
|---|---|
| 16APSK | 4 |
| 32APSK | 5 |

; et

l'ordre dans lequel les bits codés sont sortis en lecture de chaque ligne de la matrice d'entrelaceur est basé sur le schéma de modulation sélectionné et un débit de code sélectionné comme spécifié dans la table suivante, où les nombres reflétant les motifs d'entrelaceur de bits signifient chronologiquement une colonne respective de la ligne qui est sortie en lecture, avec « 0 » signifiant la colonne la plus à gauche :

| Modulation | Débit de code | Motif d'entrelaceur de bits |
|---|---|---|
| 8 PSK | 26/45 | 1-0-2 |
| 16 APSK | 26/45 | 2-1-3-0 |
| 8 PSK | 32/45 | 0-1-2 |
| 16 APSK | 32/45 | 0-1-2-3 |
| 32 APSK | 32/45 | 1-0-4-2-3 |

7. Procédé selon la revendication 6, comprenant en outre :

la modulation des trames FEC codées selon le schéma de modulation sélectionné, où le schéma de modulation sélectionné comprend un des types de modulation suivants : Modulation par déplacement de phase binaire $\pi/2$ BPSK, Modulation par déplacement de phase en quadrature QPSK, Modulation par déplacement de phase 8-PSK, Modulation par déplacement d'amplitude et de phase 16-APSK, et 32-APSK ;

dans lequel, dans le cas de $\pi/2$ BPSK or QPSK, les trames FEC codées ne sont pas entrelacées.

8. Appareil pour l'encodage, comprenant :

au moins un processeur ; et
au moins une mémoire incluant un code de programme informatique pour un ou plusieurs programmes,
ladite au moins une mémoire et le code de programme informatique configurés pour, avec le au moins un processeur, amener l'appareil à effectuer au moins ce qui suit :

l'encodage, par un processeur d'un dispositif, d'une séquence de données source de bits d'information sur la base d'une matrice de contrôle de parité structurée prédéterminée d'un code de Contrôle de parité de faible densité LDPC, où l'encodage est effectué sur la base de trames de la séquence de données source, chaque trame étant d'une longueur de $k_{ldpc}$ bits d'information $i_0, i_1, ..., i_{k_{ldpc}-1}$, et la sortie de l'encodage comprend des trames LDPC codées chacune ayant une longueur de $n_{ldpc}$ bits codés,
dans lequel la matrice de contrôle de parité structurée est représentée par des informations tabulaires d'un format où chaque ligne représente des occurrences de valeurs un à l'intérieur d'une colonne respective de la matrice de contrôle de parité, et les colonnes de la matrice de contrôle de parité sont dérivées selon une opération prédéterminée basée sur les lignes respectives des informations tabulaires, et où les informations tabulaires comprennent une des Tables **2a** à **2d** ci-dessous ;
dans lequel l'encodage comprend la génération de $n_{ldpc}$-$k_{ldpc}$ bits de parité $p_0, p_1, ..., p_{n_{ldpc}-k_{ldpc}-1}$ pour chaque trame de la séquence de données source, où la génération des bits de parité comprend :

l'initialisation d'accumulateurs de bits de parité pour $p_0, p_1, ..., p_{n_{ldpc}-k_{ldpc}-1}$ à zéro ;
l'accumulation de bit d'information $i_0$ à des adresses d'accumulateur de bits de parité spécifiées dans la première ligne des informations tabulaires ;
pour le groupe suivant de $m$ - 1 bits d'information, $i_y$ avec $y$ = 1, 2,..., $m$ - 1, l'accumulation de chaque bit d'information à des adresses d'accumulateur de bits de parité $\{x + (y \bmod m) * q\} \bmod (n_{ldpc} - k_{ldpc})$,

où $x$ désigne une adresse d'un accumulateur de bits de parité correspondant au bit d'information $i_0$, et $q$ est une constante dépendante du débit de code $q = (n_{ldpc} - k_{ldpc})/m$, et où $m$ est une constante dépendante du débit de code et m est égale à 360 et $k_{ldpc} = R * n_{ldpc}$, où $R$ est le débit de code ;

l'accumulation d'$i_m$ à des adresses d'accumulateur de bits de parité spécifiées dans la seconde ligne de la table, et, d'une manière similaire à celle pour le groupe de $m$ - 1 bits d'information ci-dessus, l'accumulation de chaque bit d'information du groupe suivant de $m$ - 1 bits d'information $i_z$, $z = m + 1$, $m + 2,....,2m$ à $\{x + (z \bmod m) * q\} \bmod(n_{ldpc} - k_{ldpc})$, où $x$ désigne l'adresse de l'accumulateur de bits de parité correspondant au bit d'information $i_m$ dans les entrées de la seconde ligne des informations tabulaires ;

de manière similaire, pour chaque groupe subséquent de $m$ bits d'information, l'accumulation des bits d'information à des adresses de bit de parité sur la base d'une ligne suivante des informations tabulaires ; et

après que la totalité des bits d'information de la trame sont accumulés, l'exécution d'opérations selon $p_i = p_i \oplus p_{i-1}$, où pour $i = 1, 2, ..., (n_{ldpc} - k_{ldpc} - 1)$, chaque $p_i$ résultant de l'opération pour un $i$ donné est égal au bit de parité $p_i$ ;

| Table 2a : Adresse d'Accumulateurs de bits de parité, Débit 11/45, $n_{ldpc}$=16200 |
|---|
| 9054 9186 12155 1000 7383 6459 2992 4723 8135 11250 |
| 2624 9237 7139 12238 11962 4361 5292 10967 11036 8105 |
| 2044 11996 5654 7568 7002 3549 4767 8767 2872 8345 |
| 6966 8473 5180 8084 3359 5051 9576 5139 1893 902 |
| 3041 3801 8252 11951 909 8535 1038 8400 3200 4585 |
| 5291 10484 10872 |
| 442 7516 3720 |
| 11469 769 10998 |
| 10575 1436 2935 |
| 6905 8610 11285 |
| 1873 5634 6383 |

| Table 2b : Adresse d'Accumulateurs de bits de parité, Débit 14/45, $n_{ldpc}$=16200 |
|---|
| 1606 3617 7973 6737 9495 4209 9209 4565 4250 7823 9384 400 |
| 4105 991 923 3562 3892 10993 5640 8196 6652 4653 9116 7677 |
| 6348 1341 5445 1494 7799 831 4952 5106 3011 9921 6537 8476 |
| 7854 5274 8572 3741 5674 11128 4097 1398 5671 7302 8155 2641 |
| 6548 2103 590 5749 5722 10 2682 1063 633 2949 207 6065 |
| 2828 6366 4766 399 935 7611 84 150 3146 |
| 5363 7455 7140 |
| 9297 482 4848 |
| 8458 1631 5344 |
| 5729 6767 4836 |
| 11019 4463 3882 |
| 4107 9610 5454 |
| 11137 4328 6307 |
| 3260 7897 3809 |

| Table 2c : Adresse d'Accumulateurs de bits de parité, Débit 26/45, $n_{ldpc}$=16200 |
|---|
| 6106 5389 698 6749 6294 1653 1984 2167 6139 6095 3832 2468 6115 |
| 4202 2362 1852 1264 3564 6345 498 6137 3908 3302 527 2767 6667 |
| 3422 1242 1377 2238 2899 1974 1957 261 3463 4994 215 2338 |

(suite)

| Table 2c : Adresse d'Accumulateurs de bits de parité, Débit 26/45, $n_{ldpc}$=16200 |
|---|
| 3016 5109 6533 2665 5300 4908 4967 5787 726 229 1970 2789 |
| 6146 5765 6649 2871 884 1670 2597 5058 3659 6594 5042 304 |
| 5521 2811 0 4214 2626 2211 1236 3771 852 6356 6797 3463 |
| 1523 1830 3938 5593 2128 5791 3421 3680 6692 1377 3808 3475 |
| 5551 6035 2247 3662 759 6783 116 6380 4586 3367 1 5003 |
| 3518 6557 6510 |
| 1830 839 4421 |
| 5431 5959 6152 |
| 3174 5113 4520 |
| 5399 1303 2496 |
| 2841 741 220 |
| 2731 1830 4193 |
| 1875 3935 223 |
| 9 4720 423 |
| 3107 2676 840 |
| 1950 6177 6457 |
| 4091 94 5102 |
| 1907 6050 3455 |
| 714 3 559 |
| 502 4268 4164 |
| 1019 5558 271 |
| 6127 854 3221 |
| 959 5337 2735 |

| Table 2d : Adresse d'Accumulateurs de bits de parité, Débit 32/45, $n_{ldpc}$=16200 |
|---|
| 2686 655 2308 1603 336 1743 2778 1263 3555 185 4212 621 |
| 286 2994 2599 2265 126 314 3992 4560 2845 2764 2540 1476 |
| 2670 3599 2900 2281 3597 2768 4423 2805 836 130 1204 4162 |
| 1884 4228 1253 2578 3053 3650 2587 4468 2784 1644 1490 4655 |
| 4258 1699 4363 4555 3810 4046 3806 344 2459 4067 3327 3510 |
| 1021 2741 2528 2168 2820 |
| 254 1080 616 |
| 1465 4192 2972 |
| 2356 2976 1534 |
| 4412 1937 2724 |
| 1430 3024 600 |
| 1952 2136 3573 |
| 3009 3123 1288 |
| 4553 2299 806 |
| 2997 402 4330 |
| 3302 4567 698 |
| 2364 498 3146 |
| 1809 647 992 |
| 3512 32 4301 |
| 1238 251 450 |
| 1657 737 641 |
| 560 1720 2893 |

(suite)

| Table 2d : Adresse d'Accumulateurs de bits de parité, Débit 32/45, $n_{ldpc}$=16200 |
|---|
| 1689 2206 902 |
| 3998 1784 2094 |
| 2090 3126 1201 |
| 1565 764 3473 |
| 891 903 2413 |
| 2286 2900 2348 |
| 3026 2033 1502 |
| 2404 1243 556 |
| 308 2222 3825 |
| 1523 3311 389 |

9. Appareil selon la revendication 8,
dans lequel le code LDPC est d'une structure qui facilite l'utilisation d'une pluralité de moteurs parallèles pour décoder les trames codées.

10. Appareil selon l'une quelconque des revendications 8 à 9, comprenant en outre :

la modulation des trames LDPC codées selon un des types de modulation suivants : Modulation par déplacement de phase binaire π/2 BPSK, Modulation par déplacement de phase en quadrature QPSK, Modulation par déplacement de phase 8-PSK, Modulation par déplacement d'amplitude et de phase 16-APSK, et 32-APSK.

11. Appareil selon l'une quelconque des revendications 8 à 10, dans lequel la séquence de données source est segmentée en une série de trames de bande de base, et le procédé comprend en outre :

l'encodage de chaque trame de bande de base sur la base d'un code Bose Chaudhuri Hocquenghem BCH d'erreur-t, où l'encodage BCH est un codage externe et l'encodage LDPC est un codage interne.

12. Appareil selon la revendication 11, comprenant en outre :

l'entrelacement de chaque trame LDPC codée en utilisant un entrelaceur de blocs, où les bits codés sont écrits dans une matrice d'entrelaceur sur une base colonne-par-colonne et sortis en lecture sur une base ligne-par-ligne, et la sortie de l'entrelacement comprend des trames FEC codées.

13. Appareil selon la revendication 12, dans lequel la matrice d'entrelaceur comprend un nombre de lignes et un nombre de colonnes, et les bits codés sont sortis en lecture de chaque ligne dans un ordre prédéterminé, et dans lequel :

le nombre de colonnes dans la matrice d'entrelaceur est basé sur un schéma de modulation sélectionné comme spécifié dans la table suivante :

| Schéma de modulation | # de colonnes de matrice d'entrelaceur |
|---|---|
| 8PSK | 3 |
| 16APSK | 4 |
| 32APSK | 5 |

; et
l'ordre dans lequel les bits codés sont sortis en lecture de chaque ligne de la matrice d'entrelaceur est basé sur le schéma de modulation sélectionné et un débit de code sélectionné comme spécifié dans la table suivante, où les nombres reflétant les motifs d'entrelaceur de bits signifient chronologiquement une colonne respective de la ligne qui est sortie en lecture, avec "0" signifiant la colonne la plus à gauche :

| Modulation | Débit de code | Motif d'entrelaceur de bits |
|------------|---------------|------------------------------|
| 8 PSK | 26/45 | 1-0-2 |
| 16 APSK | 26/45 | 2-1-3-0 |
| 8 PSK | 32/45 | 0-1-2 |
| 16 APSK | 32/45 | 0-1-2-3 |
| 32 APSK | 32/45 | 1-0-4-2-3 |

**14.** Appareil selon la revendication 13, comprenant en outre :

la modulation des trames FEC codées selon le schéma de modulation sélectionné,
dans lequel le schéma de modulation sélectionné comprend un des types de modulation suivants : Modulation par déplacement de phase binaire $\pi/2$ BPSK, Modulation par déplacement de phase en quadrature QPSK, Modulation par déplacement de phase 8-PSK, Modulation par déplacement d'amplitude et de phase 16-APSK, et 32-APSK ;
dans lequel, dans le cas de $\pi/2$ BPSK or QPSK, les trames FEC codées ne sont pas entrelacées.

**15.** Programme informatique avec un code de programme afin d'effectuer toutes les étapes selon l'une quelconque des revendications 1 à 7, lorsque le programme s'exécute sur un ordinateur ou un processeur de signal numérique.

## FIG. 1A

110

| TRANSMITTER 112 | → | CHANNEL 114 | → | RECEIVER 116 |

FIG. 1B

# FIG. 2A

EP 2 802 079 B1

# FIG. 2B

EP 2 802 079 B1

MSB of Baseband
Frame Header

WRITE                                              READ

Row 1

MSB of Baseband
Header read-out first

Row 21600

Column 1                    Column 3

LSB of FEC Frame

FIG. 3A
(Prior Art)

MSB of Baseband
Header

WRITE

READ

Row 1

MSB of Baseband
Header read-out third

Row 21600

Column 1

Column 3

LSB of FEC Frame

FIG. 3B
(Prior Art)

EP 2 802 079 B1

47

FIG. 4
(Prior Art)

## FIG. 5

600

```
┌─────────────┐
│    START    │
└──────┬──────┘
       │
       ▼
┌────────────────────────┐
│   RECEIVED SOURCE DATA  │ ── 611
│        SEQUENCE         │
└───────────┬────────────┘
            │
            ▼
┌────────────────────────┐
│  ENCAPSULATE SOURCE DATA│ ── 613
│ SEQUENCE TO FORM SEQUENCE│
│   OF BASEBAND FRAMES    │
└───────────┬────────────┘
            │
            ▼
┌────────────────────────┐
│   ENCODE BASEBAND FRAMES│ ── 615
│   BASED ON BCH CODE TO  │
│ GENERATE CODED BCH FRAMES│
│     (OUTER CODING)      │
└───────────┬────────────┘
            │
            ▼
┌────────────────────────┐
│  ENCODE CODED BCH FRAMES│ ── 617
│   BASED ON LDPC CODE TO │
│ GENERATE CODED LDPC FRAMES│
│     (INNER CODING)      │
└───────────┬────────────┘
            │
            ▼
┌────────────────────────┐
│ INTERLEAVE CODED LDPC FRAMES│ ── 619
│   TO GENERATE CODED FEC │
│         FRAMES          │
└───────────┬────────────┘
            │
            ▼
┌────────────────────────┐
│  MODULATE CODED FEC FRAMES│ ── 621
│ FOR TRANSMISSION OVER   │
│    WIRELESS CHANNEL     │
└───────────┬────────────┘
            │
            ▼
      ┌─────────────┐
      │     END     │
      └─────────────┘
```

FIG. 6

700

START

711 — RECEIVED TRANSMITTED DATA SIGNAL

713 — DETECT UNIQUE WORD HEADER AND ACQUIRE SYNCHRONIZATION

715 — DECODE HEADER AND DETERMINE MODULATION SCHEME AND CODING SCHEME (INTERLEAVING METHOD, LDPC INNER CODING AND BCH OUTER CODING) APPLIED AT TRANSMITTER

717 — DEMODULATE RECEIVED DATA SIGNAL BASED ON DETERMINED MODULATION SCHEME

719 — DE-INTERLEAVE DEMODULATED DATA SIGNALS BASED ON DETERMINED INTERLEAVING METHOD

721 — DECODE DATA SIGNALS BASED ON DETERMINED LDPC INNER CODING

723 — DECODE DATA SIGNALS BASED ON DETERMINED BCH OUTER CODING

725 — REGENERATE SOURCE DATA SEQUQNCE BASED ON DEMODULATED AND DECODED DATA SIGNAL

END

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 327316 A